# EUROPEAN PATENT APPLICATION

(11) **EP 4 535 416 A1**
(43) Date of publication of application: **09.04.2025**
(21) Application number: 23811836.8
(22) Date of filing: 24.05.2023
(51) Int. Cl.: H01L 23/29, C08F 212/36, C08L 25/02, H01L 23/31

(54) **HOLLOW PARTICLES, RESIN COMPOSITION, RESIN MOLDED BODY, RESIN COMPOSITION FOR SEALING, CURED PRODUCT AND SEMICONDUCTOR DEVICE**

(30) Priority: 26.05.2022 JP 2022086111
(71) Applicant: Zeon Corporation, Tokyo 100-8246 (JP)
(72) Inventor: MORIMURA, Miki, Tokyo 100-8246 (JP); FUJIMURA, Makoto, Tokyo 100-8246 (JP)
(74) Representative: Kraus & Lederer PartGmbB
(86) International application number: PCT/JP2023/019246
(87) International publication number: WO 2023/228964

(57) **Abstract**

To provide hollow particles in which the dielectric dissipation factor is decreased, and the performance stability in high-humidity environment is improved. Hollow particles comprising a shell, which contains a resin, and a hollow portion surrounded by the shell, wherein the hollow particles have a void ratio of 50% or more; wherein the shell contains a polymer as the resin, and a content of a crosslinkable monomer unit is 60% by mass or more in 100% by mass of all monomer units of the polymer; and wherein an aqueous dispersion of the hollow particles, which is obtained by dispersing the hollow particles with a volume of 0.35 cm³ in 100 mL of deionized water, has a pH of 6.5 or more and 7.5 or less and a conductivity of 50 µS/cm or less.

## Description

### Technical Field

The disclosure relates to hollow particles, a resin composition comprising the hollow particles, a resin molded body comprising the hollow particles, an encapsulating resin composition comprising the hollow particles, a cured product of the encapsulating resin composition, and a semiconductor device comprising the cured product as an encapsulant.

### Background Art

Hollow particles (hollow resin particles) have a hollow in their interior. Accordingly, they are added and used in resins, coating materials, various kinds of molded bodies and so on, for the purpose of weight reduction, heat insulation, a decrease in permittivity, etc. Their application covers a wide range of fields, such as automobiles, bicycles, aviation, electric, electronics, architecture, household appliances, containers, stationery products, tools and footwear.

In the electric or electronics field or the like, there is an attempt to add hollow particles to insulation materials for the purpose of decreasing the permittivity and dielectric dissipation factor of the insulation materials.

For example, Patent Document 1 discloses, as hollow crosslinking resin particles for use in organic insulation materials having low permittivity, hollow crosslinking resin particles obtained by polymerizing a crosslinking monomer (1% by weight to 100% by weight) and a non-crosslinking monomer (0% by weight to 99% by weight) (the total of the crosslinking and non-crosslinking monomers is 100% by weight), which have an average particle diameter of from 0.03 µm to 10 µm and an average concentration of metal ions present therein of 50 ppm or less. The hollow crosslinking resin particles of Patent Document 1 are produced by dispersing the monomers in water by use of an emulsifier (a surfactant) and initiating seed polymerization.

Patent Document 2 discloses hollow particles on which microspheres are attached, the particles comprising an outer shell, which contains a specific thermoplastic resin, and a foaming agent encapsulated therein. The hollow particles are particles obtained by expanding thermally expansive microspheres having an ash content of 1.2% by weight or less with heat, and attaching fine particles such as inorganic fine particles to the outer surface of the hollow particles.

Patent Document 3 discloses hollow particles obtained by dispersing an organic mixed solution in an aqueous solution containing a surfactant, and subjecting the mixed solution to suspension polymerization, wherein the organic mixed solution contains an aromatic crosslinkable monomer (a), an aromatic monofunctional monomer (b), a (meth)acrylic ester-based monomer (c) having a specific structure, a side-chain crystalline polyolefin, a polymerization initiator and an organic solvent.

Patent Document 4 discloses hollow particles which are obtained by dispersing an oil phase in an aqueous phase that is a sparingly water-soluble metal hydroxide colloid, and subjecting the obtained dispersion to suspension polymerization, wherein the oil phase contains a hydrocarbon monomer in which a content of a crosslinkable monomer is 70% by mass or more, a hydrocarbon solvent containing 5 to 8 carbon atoms, and a polymerization initiator.

### Citation List

### Patent Documents

Patent Document 1: Japanese Patent Application Laid-Open (JP-A) No. 2000-313818
Patent Document 2: JP-A No. 2015-003951
Patent Document 3: International Publication No. WO2021/085189
Patent Document 4: International Publication No. WO2022/092076

### Summary

### Technical Problem

Hollow particles which are added for the purpose of decreasing the dielectric dissipation factor of various kinds of materials, are desired to have a lower dielectric dissipation factor.

In addition, on electronic circuit boards, such hollow particles are required to have performance stability in high-humidity environment. For example, they are required not to cause a failure in high-humidity environment, such as ion migration (a phenomenon in which ionized metal migrates between the electrodes to cause short circuit). However, on an electronic circuit board containing hollow particles, in some cases, ion migration is likely to occur in high-humidity environment.

An object of the present disclosure is to provide hollow particles in which the dielectric dissipation factor is decreased, and the performance stability in high-humidity environment is improved.

Another object of the present disclosure is to provide a resin composition and a resin molded body in both of which, because of containing the hollow particles, a reduction in the performance stability under high-humidity environment is suppressed, while the dielectric dissipation factor is decreased.

Another object of the present disclosure is to provide an encapsulating resin composition and a cured product thereof as the resin composition and the resin molded body, and to provide a semiconductor device comprising the cured product of the encapsulating resin composition as an encapsulant.

### Solution to Problem

The inventor of the present disclosure found that when a metal or surfactant is contained in hollow particles so that it can be easily eluted into water, an increase in the dielectric dissipation factor of the hollow particles and a reduction in the performance stability of the hollow particles in high-humidity environment are likely to occur. Finally, the inventor achieved the present disclosure, based on this finding.

According to the present disclosure, hollow particles comprising a shell, which contains a resin, and a hollow portion surrounded by the shell are provided,
wherein the hollow particles have a void ratio of 50% or more;
wherein the shell contains a polymer as the resin, and a content of a crosslinkable monomer unit is 60% by mass or more in 100% by mass of all monomer units of the polymer; and
wherein an aqueous dispersion of the hollow particles, which is obtained by dispersing the hollow particles with a volume of 0.35 cm³ in 100 mL of deionized water, has a pH of 6.5 or more and 7.5 or less and a conductivity of 50 µS/cm or less.

In the hollow particles of the present disclosure, a content of a hydrocarbon monomer unit is preferably more than 50% by mass in 100% by mass of all the monomer units of the polymer.

The hollow particles of the present disclosure preferably have a metal content of 700 ppm or less.

In the hollow particles of the present disclosure, a content of a surfactant present on a surface of the hollow particles is preferably 200 ppm or less.

The hollow particles of the present disclosure preferably have a dielectric dissipation factor at a frequency of 10 GHz of 1.00 × 10⁻³ or less.

The hollow particles of the present disclosure preferably have a relative permittivity at a frequency of 10 GHz of 1.00 or more and 1.40 or less.

The hollow particles of the present disclosure preferably have a void ratio of 70% or more.

Also, according to the present disclosure, a resin composition comprising the hollow particles of the present disclosure and a matrix resin is provided.

Also, according to the present disclosure, a resin molded body obtained from the resin composition of the present disclosure is provided.

Also, according to the present disclosure, an encapsulating resin composition comprising the hollow particles of the present disclosure and an epoxy resin is provided.

Also, according to the present disclosure, a cured product of the encapsulating resin composition of the present disclosure is provided.

Also, according to the present disclosure, a semiconductor device comprising the cured product of the present disclosure as an encapsulant is provided.

### Advantageous Effects of Invention

As described above, the present disclosure provides the hollow particles in which the dielectric dissipation factor is decreased, and the performance stability in high-humidity environment is improved.

Also, the present disclosure provides the resin composition and the resin molded body in both of which, because of containing the hollow particles, a reduction in the performance stability in high-humidity environment is suppressed, while the dielectric dissipation factor is decreased.

Also, the present disclosure especially provides the encapsulating resin composition and the cured product thereof as the resin composition and the resin molded body. Also, the present disclosure provides the semiconductor device comprising the cured product of the encapsulating resin composition as an encapsulant.

### Brief Description of Drawing

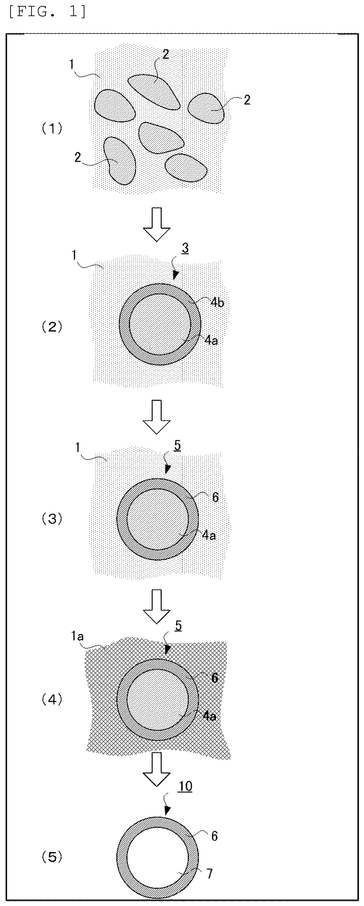

[FIG. 1] A diagram illustrating an example of the method for producing the hollow particles of the present disclosure.

### Description of Embodiments

The hollow particles of the present disclosure are hollow particles comprising a shell, which contains a resin, and a hollow portion surrounded by the shell,
wherein the hollow particles have a void ratio of 50% or more;
wherein the shell contains a polymer as the resin, and a content of a crosslinkable monomer unit is 60% by mass or more in 100% by mass of all monomer units of the polymer; and
wherein an aqueous dispersion of the hollow particles, which is obtained by dispersing the hollow particles with a volume of 0.35 cm³ in 100 mL of deionized water, has a pH of 6.5 or more and 7.5 or less and a conductivity of 50 µS/cm or less.

The hollow particles of the present disclosure are hollow particles in which the contents of a metal and a surfactant, which are contained in a manner that they can be easily eluted into water, are sufficiently small. Accordingly, an increase in the dielectric dissipation factor of the hollow particles, and a reduction in the performance stability of the hollow particles in high-humidity environment, both of which are due to the metal or surfactant, are suppressed. In the hollow particles of the present disclosure, both the content of the metal and that of the surfactant are sufficiently small. Accordingly, compared to the case of decreasing the content of only one of them, the effect of decreasing the dielectric dissipation factor and the effect of improving the performance stability in high-humidity environment are significantly excellent. The hollow particles of the present disclosure are highly effective in suppressing the occurrence of ion migration on electronic circuit boards containing the hollow particles since the content of, among surfactants, an ionic surfactant present on the particle surface is decreased.

In the aqueous dispersion obtained by dispersing the hollow particles in the deionized water, the conductivity tends to increase as the content of the metal or ionic surfactant eluted from the hollow particles increases; the pH tends to increase as the amount of the metal eluted from the hollow particles increases; and the pH tends to be basic (more than 7.5) when the ionic surfactant content is equal to or more than a certain value.

The inventor of the present disclosure found the following: as the contents of the metal and ionic surfactant eluted from the hollow particles into the aqueous dispersion increase, the dielectric dissipation factor of the hollow particles tends to increase; the performance stability of the hollow particles in high-humidity environment tends to deteriorate, especially, ion migration is likely to occur on the electronic circuit board containing the hollow particles. The dielectric dissipation factor is "the degree that a part of the energy is turned into heat and lost when an electric field is applied". It is estimated that the metal and ionic surfactant eluted from the hollow particles into the aqueous dispersion are attached to the particle surface while being in a state where they can be easily released from the hollow particles, and the metal and ionic surfactant are attached to the particle surface when the particles are in a dry state. It is estimated that since the metal is attached to the particle surface, polarization is generated when applying an electric field, and the dielectric dissipation factor of the hollow particles is increased, accordingly. It is also estimated that since the surfactant is attached to the particle surface, water in the air is likely to be absorbed, and the dielectric dissipation factor of the hollow particles is increased, accordingly.

It is also estimated that when the metal or surfactant is attached to the surface of the hollow particles, on an electronic circuit board in which the hollow particles are contained in an insulating resin layer, the metal or surfactant absorbs water and is likely to be ionized in high-humidity environment; a dendrite is likely to be generated; and ion migration is likely to occur, accordingly. When, among surfactants, the ionic surfactant is attached to the surface of the hollow particles, due to the large content of the ionic component of the surfactant around the surface of the hollow particles, metal ionization is further promoted, and ion migration is more likely to occur, accordingly.

Since the above-described aqueous dispersion of the hollow particles of the present disclosure has a pH of 6.5 or more and 7.5 or less and a conductivity of 50 µS/cm or less, the contents of the metal and ionic surfactant, which are contained in the hollow particles in a manner that they are likely to affect especially the dielectric dissipation factor and performance stability in high-humidity environment of the hollow particles, are estimated to be reduced.

The hollow particles of the present disclosure are typically produced by the suspension polymerization method, from the following points of view: the hollow particles can be easily produced; impurities attached to the particle surface can be easily removed; and the particle diameter of the hollow particles can be easily controlled to a desired particle diameter. In the suspension polymerization method in which a polymerizable monomer containing 60% by mass or more of a crosslinkable monomer is used, in monomer composition droplets dispersed in a suspension, a component constituting a shell and a hydrophobic solvent are likely to cause a phase separation; moreover, since a shell with excellent strength is formed, particle deformation is suppressed. A hollow portion that is clearly distinguished from the shell is formed, accordingly. Since the hollow particles of the present disclosure are produced by the suspension polymerization method in which, as just described, a polymerizable monomer containing a large amount of a crosslinkable monomer is used, they are hollow particles in which the content of the crosslinkable monomer unit is 60% by mass or more in 100% by mass of all the monomer units of the polymer constituting the shell, and which have the hollow portion that is clearly differentiated from the shell. In addition, since the shell with excellent strength is formed, shell deformation is suppressed; a sufficiently high void ratio of 50% or more can be obtained; and a low dielectric dissipation factor can be achieved, accordingly. An air layer has a dielectric dissipation factor of 0, and the dielectric dissipation factor decreases as the percentage of the air layer in the hollow particles increases. Accordingly, the hollow particles with a higher void ratio achieve a lower dielectric dissipation factor.

By using, in the hollow particles produced by the suspension polymerization method, an inorganic dispersion stabilizer as the dispersion stabilizer and not using a surfactant, the hollow particles free of a surfactant can be obtained. However, in the case of using the inorganic dispersion stabilizer as the dispersion stabilizer, a metal that can be eluted into water is likely to remain on the surface of the obtained hollow particles. To sufficiently decrease the amount of the metal remaining on the particle surface and to obtain a pH of 6.5 or more and 7.5 or less and a conductivity of 50 µS/cm or less in the above-described aqueous dispersion of the hollow particles, in the production of the hollow particles, for example, it is preferable to control the polymerization temperature to 80°C or more in the polymerization step, and it is preferable to employ a preferred method described below in the washing step.

In the present disclosure, the aqueous dispersion of the hollow particles subjected to pH and conductivity measurements may further contain a dispersant, as long as the conductivity is 2 µS/cm or less in the absence of the hollow particles. The type and content of the dispersant is appropriately adjusted so that the hollow particles are uniformly dispersed. The aqueous dispersion of the hollow particles subjected to pH and conductivity measurements is found to be in such a state by visual confirmation, that powder (the hollow particles) is not present in the upper part and is entirely dispersed in the water.

As the dispersant that can be used in the aqueous dispersion of the hollow particles for pH and conductivity measurements, such a dispersant can be appropriately selected and used, that when added to deionized water, it does not cause a change in the pH or conductivity of the deionized water. For example, a non-ionic surfactant can be used.

The non-ionic surfactant is not particularly limited, and it can be selected from known non-ionic surfactants and used. As the non-ionic surfactant, examples include, but are not limited to, a polyoxyalkylene-type non-ionic surfactant such as a higher alcohol alkylene oxide adduct, an alkylphenol alkylene oxide adduct, a fatty acid alkylene oxide adduct, a higher alkylamine alkylene oxide adduct, a polyhydric alcohol aliphatic ester alkylene oxide adduct, a polypropylene glycol ethylene oxide adduct, a fatty acid amide alkylene oxide adduct, and a polyoxyalkylene styrenated phenyl ether; a polyhydric alcohol-type non-ionic surfactant such as a polyethylene oxide, a fatty acid ester of glycerin, an alkyl glycoxide, a fatty acid ester of pentaerythritol, a fatty acid ester of sorbit or sorbitan, a sucrose fatty acid ester, an alkyl ether of polyhydric alcohol, and an aliphatic amide of alkanolamine; and a non-ionic polymer compound containing both a hydrophilic group and a hydrophobic group, such as polyvinyl alcohol and polyvinylpyrrolidone. Of them, polyoxyalkylene-type non-ionic surfactant is preferably used.

In the aqueous dispersion of the hollow particles, the concentration of the non-ionic surfactant is not particularly limited. For example, it can be from 0.05% by mass to 1% by mass.

Also in the present disclosure, the hollow particles added to the aqueous dispersion used for pH and conductivity measurements, are hollow particles just before use. The hollow particles just before use are, in the case where they are hollow particles that are mixed and used with different materials, those just before being mixed with the different materials. The hollow particles just before use are, in the case where they are hollow particles that are used alone as a coating material or the like, those just before being used for that purpose. In the case of measuring the pH and conductivity of the aqueous dispersion of hollow particles produced in the form of a dispersant, by the same method as the solvent removal step of the below-described hollow particle production method, dried hollow particles in which the hollow portion is filled with gas are obtained from a dispersion; an aqueous dispersion is prepared by dispersing the dried hollow particles with a volume of 0.35 cm³ in 100 mL of deionized water; and the pH and conductivity of the aqueous dispersion are measured.

In the present disclosure, as the hollow particles with a volume of 0.35 cm³, hollow particles having the weight (g) obtained by the following formula (1) are measured, collected and used. In the following formula (1), the apparent density D₁ of the hollow particles is the same as the apparent density D₁ of the hollow particles measured to obtain the void ratio described below. Weight (g) of the hollow particles with a volume of 0.35 cm3 = Apparent density D1 (g/cm3) of the hollow particles × 0.35 (cm3)

The aqueous dispersion of the hollow particles is only required to have a pH of 6.5 or more and 7.5 or less. From the viewpoint of decreasing the dielectric dissipation factor of the hollow particles and improving the performance stability of the hollow particles in high-humidity environment, the pH is preferably 6.8 or more and 7.3 or less, and more preferably 6.9 or more and 7.2 or less.

The aqueous dispersion of the hollow particles is only required to have a conductivity of 50 µS/cm or less. From the viewpoint of decreasing the dielectric dissipation factor of the hollow particles and improving the performance stability of the hollow particles in high-humidity environment, the conductivity is preferably 40 µS/cm or less, more preferably 30 µS/cm or less, and still more preferably 20 µS/cm or less. The lower limit of the conductivity is not particularly limited. For example, the lower limit may be 5 µS/cm or more, or it may be 10 µS/cm or more.

Hereinafter, an example of the method for producing the hollow particle of the present disclosure will be described. Then, the hollow particles of the present disclosure will be described in more detail.

In the present disclosure, "to" which shows a numerical range is used to describe a range in which the numerical values described before and after "to" indicate the lower limit value and the upper limit value.

### 1. Method for producing the hollow particles

As the hollow particle production method of the present disclosure, for example, there is provided a method comprising:
preparing a mixture liquid containing a polymerizable monomer, a hydrophobic solvent, a polymerization initiator, a dispersion stabilizer and an aqueous medium,
suspending the mixture liquid to prepare a suspension in which droplets of a monomer composition containing the polymerizable monomer, the hydrophobic solvent and the polymerization initiator are dispersed in the aqueous medium,
subjecting the suspension to a polymerization reaction to prepare a precursor composition comprising precursor particles comprising a shell, which contains a resin, and a hollow portion surrounded by the shell and including the hydrophobic solvent in the hollow portion, and
washing the precursor particles.

The above-described production method follows the following basic technique. By carrying out a suspension treatment of the mixture liquid containing the polymerizable monomer, the hydrophobic solvent, the polymerization initiator, the dispersion stabilizer and the aqueous medium, phase separation occurs between the polymerizable monomer and the hydrophobic solvent. Accordingly, the suspension in which droplets are dispersed in the aqueous medium, the droplets having a distribution structure such that the polymerizable monomer is distributed on the surface side and the hydrophobic solvent is distributed in the center, is prepared. Then, by subjecting the suspension to a polymerization reaction, the surface of the droplets is cured, and the hollow particles having the hollow portion filled with the hydrophobic solvent are formed, accordingly.

In the present disclosure, the hollow particles in which the hollow portion is filled with the hydrophobic solvent may be referred to as "precursor particles", considering that they are an intermediate of the hollow particles in which the hollow portion is filled with gas. In the present disclosure, "precursor composition" means a composition containing the precursor particles.

The above-described production method includes the steps of preparing the mixture liquid, preparing the suspension, subjecting the suspension to a polymerization reaction, and washing the precursor particles. The method may further include other steps. As far as technically possible, two or more of the above steps and other additional steps may be simultaneously carried out as one step, or their order may be changed and then they may be carried out in that order. For example, the preparation and suspension of the mixture liquid may be simultaneously carried out in one step (e.g., the mixture liquid may be suspended while adding the materials for the mixture liquid).

A preferred embodiment of the method for producing the hollow particles of the present disclosure may be a production method including the following steps.

### (1) Mixture liquid preparation step

The mixture liquid preparation step includes preparing a mixture liquid containing a polymerizable monomer, a hydrophobic solvent, a polymerization initiator, a dispersion stabilizer and an aqueous medium.

### (2) Suspension step

The suspension step includes suspending the mixture liquid to prepare a suspension in which droplets of a monomer composition containing the polymerizable monomer, the hydrophobic solvent and the polymerization initiator are dispersed in the aqueous medium.

### (3) Polymerization step

The polymerization step includes subjecting the suspension to a polymerization reaction to prepare a precursor composition comprising precursor particles comprising a shell, which contains a resin, and a hollow portion surrounded by the shell and including the hydrophobic solvent in the hollow portion.

### (4) Washing step

The washing step includes washing the precursor particles.

### (5) Solvent removal step

The solvent removal step includes removing the included hydrophobic solvent from the precursor particles to obtain the hollow particles.

FIG. 1 is a schematic diagram showing an example of the production method of the present disclosure. The diagrams (1) to (5) in FIG. 1 correspond to the steps (1) to (5) described above, respectively. White arrows between the diagrams indicate the order of the steps. FIG. 1 is merely a schematic diagram for description, and the production method of the present disclosure is not limited to the method shown in FIG. **1****.** Further, the structures, dimensions and shapes of materials used for the production method of the present disclosure are not limited to the structures, dimensions and shapes of various materials shown in these diagrams.

The diagram (1) of FIG. 1 is a schematic cross-sectional view showing an embodiment of the mixture liquid in the mixture liquid preparation step. As shown in the diagram, the mixture liquid contains an aqueous medium 1 and a low polarity material 2 dispersed in the aqueous medium 1. Here, the low polarity material 2 means a material that has low polarity and is less likely to mix with the aqueous medium 1. In the present disclosure, the low polarity material 2 contains the polymerizable monomer, the hydrophobic solvent and the polymerization initiator.

The diagram (2) of FIG. 1 is a schematic cross-sectional view showing an embodiment of the suspension in the suspension step. The suspension contains the aqueous medium 1 and droplets 3 of the monomer composition dispersed in the aqueous medium **1.** The droplets 3 of the monomer composition contain the polymerizable monomer, the hydrophobic solvent and the polymerization initiator, and their distribution in the droplets is not uniform. The droplets 3 of the monomer composition have the following structure: phase separation occurs between a hydrophobic solvent 4a and a material 4b containing the polymerizable monomer and not containing the hydrophobic solvent; the hydrophobic solvent 4a is distributed in the center; the material 4b not containing the hydrophobic solvent is distributed on the surface side; and the dispersion stabilizer (not shown) is on the surface.

The diagram (3) of FIG. 1 is a schematic cross-sectional view showing an embodiment of the precursor composition obtained by the polymerization step, which contains the precursor particles which include the hydrophobic solvent in the hollow portion. The precursor composition contains the aqueous medium 1 and precursor particles 5 which include the hydrophobic solvent 4a in the hollow portion and which are dispersed in the aqueous medium 1. A shell 6 forming the outer surface of the precursor particles 5 is formed by polymerization of the polymerizable monomer contained in the droplets 3 of the monomer composition. The shell 6 contains the polymer of the polymerizable monomer as the resin.

The diagram (4) of FIG. 1 is a schematic cross-sectional view showing an embodiment of the precursor particles in the washing step. The diagram (4) of FIG. 1 shows a state where the precursor particles 5 have been separated from the state shown in the diagram (3) of FIG. 1 and reslurried by deionized water 1a.

The diagram (5) of FIG. 1 is a schematic cross-sectional view showing an embodiment of the hollow particles after the solvent removal step. The diagram (5) of FIG. 1 shows a state where the deionized water 1a and the hydrophobic solvent 4a have been removed from the state shown in the diagram (4) of FIG. 1. By the removal of the included hydrophobic solvent from the precursor particles, hollow particles 10 having a gas-filled hollow portion 7 in the interior of the shell 6, are obtained.

Hereinafter, the five steps described above and other steps will be described in order.

### (1) Mixture liquid preparation step

The mixture liquid preparation step includes preparing a mixture liquid containing a polymerizable monomer, a hydrophobic solvent, a polymerization initiator, a dispersion stabilizer and an aqueous medium. The mixture liquid may further contain other materials to the extent that does not impair the effects of the present disclosure.

The materials for the mixture liquid will be described in the following order: (A) the polymerizable monomer, (B) the hydrophobic solvent, (C) the polymerization initiator, (D) the dispersion stabilizer and (E) the aqueous medium.

### (A) polymerizable monomer

In the present disclosure, the polymerizable monomer is a compound containing an addition-polymerizable functional group (in the present disclosure, it may be simply referred to as "polymerizable functional group"). In the present disclosure, as the polymerizable monomer, a compound containing an ethylenically unsaturated bond as the addition-polymerizable functional group, is generally used.

In the present disclosure, a known polymerizable monomer conventionally used for the production of hollow polymer particles can be used as the polymerizable monomer, without particular limitation. From the point of view that the hollow portion is easily formed in the interior of the particles, the polymerizable monomer preferably contains a crosslinkable monomer, and it may further contain a non-crosslinkable monomer. When the polymerizable monomer contains a crosslinkable monomer, in the polymerization reaction of the suspension, the crosslinking density of the polymer precipitated on the surface of the droplets increases, and the precipitates are crosslinked. Accordingly, the crosslinking density of the shell can be improved. As a result, the shell excellent in strength is easily formed; the thus-obtained hollow particles easily become spherical; and the hollow portion that is clearly distinguished from the shell is easily formed in the interior of the particles.

In the present disclosure, a polymerizable monomer which has only one polymerizable functional group is referred to as a non-crosslinkable monomer, and a polymerizable monomer which has two or more polymerizable functional groups is referred to as a crosslinkable monomer. The crosslinkable monomer is a polymerizable monomer which forms crosslinking in resin by polymerization reaction.

Also in the present disclosure, a polymerizable monomer composed of the elements carbon and hydrogen is referred to as "hydrocarbon monomer"; a crosslinkable monomer composed of the elements carbon and hydrogen is referred to as "crosslinkable hydrocarbon monomer"; and a non-crosslinkable monomer composed of the elements carbon and hydrogen is referred to as "non-crosslinkable hydrocarbon monomer". Also in the present disclosure, a polymerizable monomer containing a (meth)acryloyl group as a polymerizable functional group is referred to as "acrylic monomer"; a crosslinkable monomer containing a (meth)acryloyl group as a polymerizable functional group is referred to as "crosslinkable acrylic monomer"; and a non-crosslinkable monomer containing a (meth)acryloyl group as a polymerizable functional group is referred to as "non-crosslinkable acrylic monomer". In the crosslinkable acrylic monomer, at least one polymerizable functional group is only required to be a (meth)acryloyl group, and all polymerizable functional groups are preferably (meth)acryloyl groups.

Also in the present disclosure, (meth)acrylate means each of acrylate and methacrylate; (meth)acryl means each of acryl and methacryl; and (meth)acryloyl means each of acryloyl and methacryloyl.

As the crosslinkable monomer, examples include, but are not limited to, the following: a difunctional crosslinkable hydrocarbon monomer such as an aromatic divinyl monomer (e.g., divinylbenzene, divinylbiphenyl and divinylnaphthalene), a diene monomer (e.g., butadiene, isoprene, 2,3-dimethylbutadiene, pentadiene and hexadiene) and an alicyclic olefin (e.g., dicyclopentadiene, cyclopentadiene and ethylidene tetracyclododecene; a polymer-type crosslinkable hydrocarbon monomer such as polybutadiene, polyisoprene, SBS (a block copolymer of styrene and butadiene) and SIS (a block copolymer of styrene and isoprene); a difunctional crosslinkable acrylic monomer such as allyl (meth)acrylate, vinyl (meth)acrylate, ethylene glycol di(meth)acrylate, diethylene glycol di(meth)acrylate, pentaerythritol di(meth)acrylate, tricyclodecane dimethanol di(meth)acrylate and 3-(meth)acryloyloxy-2-hydroxypropyl (meth)acrylate; a trifunctional or higher-functional crosslinkable acrylic monomer such as trimethylolpropane tri(meth)acrylate, ditrimethylolpropane tetra(meth)acrylate, pentaerythritol tri(meth)acrylate, pentaerythritol tetra(meth)acrylate, dipentaerythritol hexa(meth)acrylate, dipentaerythritol poly(meth) acrylate, and ethoxylates thereof; a crosslinkable allyl monomer such as diallyl phthalate; a polymer-type crosslinkable acrylic monomer such as both-(meth)acrylic-terminated polyphenylene ether; and a polymer-type crosslinkable vinyl monomer such as both-vinyl-terminated polyphenylene ether. These crosslinkable monomers may be used alone or in combination of two or more.

As the non-crosslinkable monomer, examples include, but are not limited to, the following: a non-crosslinkable hydrocarbon monomer such as an aromatic monovinyl monomer (e.g., styrene, vinyl toluene, α-methylstyrene, p-methylstyrene, ethylvinylbenzene, ethylvinylbiphenyl and ethylvinylnaphthalene), a monoolefin monomer (e.g., ethylene, propylene and butylene) and an alicyclic monoolefin (e.g., vinylcyclohexane, norbornene and tricyclododecene); a non-crosslinkable acrylic monomer such as methyl (meth)acrylate, ethyl (meth)acrylate, butyl (meth)acrylate, 2-ethylhexyl (meth)acrylate, lauryl (meth)acrylate), t-butylaminoethyl (meth)acrylate, glycidyl (meth)acrylate, 2-hydroxyethyl (meth)acrylate, 2-aminoethyl (meth)acrylate, (meth)acrylic acid, (meth)acrylamide, N-methylol (meth)acrylamide, N-butoxymethyl (meth)acrylamide, methoxypolyethylene glycol (meth)acrylate, ethoxypolyethylene glycol (meth)acrylate, propoxypolyethylene glycol (meth)acrylate, butoxypolyethylene glycol (meth)acrylate, hexaoxypolyethylene glycol (meth)acrylate, octoxypolyethylene glycol polypropylene glycol (meth)acrylate, lauroxypolyethylene glycol (meth)acrylate, stearoxypolyethylene glycol (meth)acrylate, phenoxypolyethylene glycol polypropylene glycol (meth)acrylate, polyethylene glycol mono(meth)acrylate, polypropylene glycol mono(meth)acrylate, polyethylene glycol propylene glycol mono(meth)acrylate, polyethylene glycol tetramethylene glycol (meth)acrylate, propylene glycol polybutylene glycol mono (meth) acrylate, and monoethylene glycol mono(meth)acrylate; a carboxylic acid vinyl ester monomer such as vinyl acetate; a halogenated aromatic vinyl monomer such as halogenated styrene; a vinyl halide monomer such as vinyl chloride; a vinylidene halide monomer such as vinylidene chloride; and vinylpyridine. Also, a polymer-type non-crosslinkable monomer such as mono-(meth)acrylic-terminated polystyrene and mono-(meth)acrylic-terminated polymethyl methacrylate may be used, for example. These non-crosslinkable monomers may be used alone or in combination of two or more.

In 100 parts by mass of the polymerizable monomer, the content of the crosslinkable monomer is preferably 60 parts by mass or more, more preferably 70 parts by mass or more, and still more preferably 80 parts by mass or more, from the point of view that the pressure resistance of the hollow particles is improved, and the void ratio of the hollow particles is easily kept high. On the other hand, in 100 parts by mass of the polymerizable monomer, the content of the crosslinkable monomer is preferably 96 parts by mass or less, more preferably 90 parts by mass or less, and still more preferably 85 parts by mass or less, from the point of view that the dielectric dissipation factor of the hollow particles is easily decreased.

From the point of view that the polymerization reaction is easily stabilized, the polymerizable monomer is preferably a polymerizable monomer in which the polymerizable functional group is a (meth)acryloyl group or a vinyl group. In the present disclosure, "the polymerization reaction is stabilized" means that the reactivity of the polymerization reaction is excellent, and the polymerization reaction uniformly proceeds. In the present disclosure, in 100 parts by mass of the polymerizable monomer, the content of the polymerizable monomer in which the polymerizable functional group is a (meth)acryloyl group or a vinyl group, is preferably 80 parts by mass or more, more preferably 90 parts by mass or more, and still more preferably 95 parts by mass or more.

From the viewpoint of improving the dielectric property of the hollow particles, in 100 parts by mass of the polymerizable monomer, the content of the hydrocarbon monomer is preferably more than 50 parts by mass, more preferably 70 parts by mass or more, still more preferably 90 parts by mass or more, and even more preferably 95 parts by mass or more. The polymerizable monomer may be composed of a hydrocarbon monomer. As the percentage of the hydrocarbon monomer in the polymerizable monomer increases, the relative permittivity and dielectric dissipation factor of the hollow particles tend to decrease.

In the present disclosure, as the relative permittivity and dielectric dissipation factor decrease, the dielectric property improves.

From the viewpoint of achieving excellent pressure resistance while improving the dielectric property of the hollow particles, the hydrocarbon monomer preferably contains at least a crosslinkable hydrocarbon monomer. The crosslinkable hydrocarbon monomer is preferably an aromatic divinyl monomer, and more preferably divinylbenzene.

From the viewpoint of improving especially the dielectric property of the hollow particles, as the hydrocarbon monomer, a combination of a crosslinkable hydrocarbon monomer and a non-crosslinkable hydrocarbon monomer is preferably contained. The non-crosslinkable hydrocarbon monomer is preferably an aromatic monovinyl monomer, and more preferably at least one selected from the group consisting of ethylvinylbenzene and styrene.

The content of the polymerizable monomer in the mixture liquid is not particularly limited. From the viewpoint of the balance of the void ratio, particle diameter and mechanical strength of the hollow particles, with respect to the total mass (100% by mass) of the components (except for the aqueous medium) in the mixture liquid, the content of the polymerizable monomer is preferably from 15% by mass to 50% by mass, more preferably from 20% by mass to 40% by mass, and still more preferably from 20% by mass to 30% by mass.

From the viewpoint of suppressing a deterioration in the dielectric property of the obtained hollow particles, a decrease in the strength thereof, and a reduction in the performance stability in high-humidity environment thereof, the content of the polymerizable monomer is preferably 96% by mass or more, and more preferably 97% by mass or more, with respect to the total mass (100% by mass) of a solid content obtained by excluding the hydrophobic solvent from the material for the oil phase in the mixture liquid.

In the present disclosure, the solid content includes all components excluding solvent, and a liquid polymerizable monomer and the like are included in the solid content.

### (B) Hydrophobic solvent

The hydrophobic solvent used in the production method of the present disclosure is a non-polymerizable, sparingly water-soluble organic solvent.

The hydrophobic solvent serves as a spacer material for forming the hollow portion in the interior of the particles. In the suspension step described later, the suspension in which the droplets of the monomer composition containing the hydrophobic solvent are dispersed in the aqueous medium, is obtained. In the suspension step, phase separation occurs in the droplets of the monomer composition. As a result, the hydrophobic solvent with low polarity is likely to collect in the interior of the droplets of the monomer composition. In the end, according to their respective polarities, the hydrophobic solvent is distributed in the interior of the droplets of the monomer composition, and the material not containing the hydrophobic solvent is distributed at the periphery of the droplets of the monomer composition.

Then, in the polymerization step described later, an aqueous dispersion containing the precursor particles including the hydrophobic solvent, is obtained. That is, since the hydrophobic solvent collects in the interior of the particles, the hollow portion filled with the hydrophobic solvent is formed in the interior of the obtained precursor particles.

The hydrophobic solvent can be appropriately selected from known hydrophobic solvents, without particular limitation. As the hydrophobic solvent, examples include, but are not limited to, an ester such as ethyl acetate and butyl acetate; an ether ester such as propylene glycol monomethyl ether acetate and propylene glycol monoethyl ether acetate; and a hydrocarbon solvent. Of them, a hydrocarbon solvent is preferably used.

As the hydrocarbon solvent, examples include, but are not limited to, an aromatic hydrocarbon solvent such as benzene, toluene and xylene, and aliphatic hydrocarbons including a chain hydrocarbon solvent such as pentane, hexane, heptane, octane, 2-methylbutane, 2-methylpentane and a paraffin-based solvent, and a cyclic hydrocarbon solvent such as cyclohexane, methylcyclohexane and cycloheptane.

These hydrophobic solvents may be used alone or in combination of two or more.

From the point of view that phase separation easily occurs between the polymerizable monomer and hydrophobic solvent in the droplets of the monomer composition during the suspension step, such an organic solvent is preferably selected as the hydrophobic solvent, that the water solubility of the organic solvent is smaller than that of the crosslinkable monomer contained in the polymerizable monomer.

When the polymerizable monomer contains the hydrocarbon monomer in an amount of more than 50% by mass, a chain hydrocarbon solvent is preferably used as the hydrophobic solvent; a chain hydrocarbon solvent containing 5 to 8 carbon atoms is more preferably used as the hydrophobic solvent; and at least one selected from the group consisting of pentane, hexane, heptane and octane is still more preferably used as the hydrophobic solvent.

The boiling point of the hydrophobic solvent is not particularly limited. From the viewpoint of ease of removal in the solvent removal step described later, the boiling point of the hydrophobic solvent is preferably 130°C or less, and more preferably 100°C or less. On the other hand, the boiling point of the hydrophobic solvent is preferably 50°C or more, and more preferably 60°C or more, from the point of view that the hydrophobic solvent can be easily included in the precursor particles.

When the hydrophobic solvent is a mixed solvent containing several kinds of hydrophobic solvents and it has several boiling points, the boiling point of the solvent having the highest boiling point among the solvents contained in the mixed solvent, is preferably equal to or less than the upper limit value, and the boiling point of the solvent having the lowest boiling point among the solvents contained in the mixed solvent, is preferably equal to or more than the lower limit value.

The relative permittivity at 20°C of the hydrophobic solvent used in the production method of the present disclosure, is preferably 2.5 or less, and more preferably 2.0 or less. The relative permittivity is one of the indices of the level of the polarity of a compound. In the case where the hydrophobic solvent has a sufficiently small relative permittivity of preferably 2.5 or less, and more preferably 2.0 or less, it is considered that phase separation progresses rapidly in the droplets of the monomer composition and the hollow portion is easily formed.

Examples of hydrophobic solvents having a relative permittivity at 20°C of 2.0 or less, are as follows. The inside of the parentheses is the value of relative permittivity.

Pentane (1.8), hexane (1.9), heptane (1.9), octane (1.9), cyclohexane (2.0).

For the relative permittivity at 20°C, values written in known literatures (for example, the Chemical Society of Japan, as editor, "Kagaku Binran, Kiso Hen, Kaitei 4 Ban", pp. II-498 to II-503, published by Maruzen Publishing Co., Ltd. on September 30, 1993) and other technical information may be used as reference. Examples of the method of measuring the relative permittivity at 20°C include a relative permittivity test that is in conformity with 23 of JIS C 2101:1999 and is performed with the measuring temperature set to 20°C.

The void ratio of the hollow particles can be controlled by changing the amount of the hydrophobic solvent in the mixture liquid. In the suspension step described later, the polymerization reaction progresses while oil droplets containing the polymerizable monomer and so on include the hydrophobic solvent. Accordingly, as the content of the hydrophobic solvent increases, the void ratio of the obtained hollow particles tends to increase.

In the present disclosure, with respect to 100 parts by mass of the polymerizable monomer, the content of the hydrophobic solvent in the mixture liquid is preferably 50 parts by mass or more and 500 parts by mass or less, from the following viewpoints: the particle diameter of the hollow particles is easily controlled; the void ratio is easily increased while maintaining the strength of the hollow particles; and the amount of the residual hydrophobic solvent in the hollow particles is easily reduced. The content of the hydrophobic solvent in the mixture liquid is more preferably 70 parts by mass or more and 300 parts by mass or less, and still more preferably 80 parts by mass or more and 200 parts by mass or less, with respect to 100 parts by mass of the polymerizable monomer.

### (C) Polymerization initiator

In the production method of the present disclosure, the mixture liquid preferably contains an oil-soluble polymerization initiator as the polymerization initiator. The oil-soluble polymerization initiator is not particularly limited, as long as it is a lipophilic one having a solubility in water of 0.2% by mass or less. As the oil-soluble polymerization initiator, examples include, but are not limited to, an organic peroxide such as benzoyl peroxide, lauroyl peroxide, t-butyl peroxy-2-ethylhexanoate, t-butylperoxy diethylacetate and t-butylperoxy pivalate, and an azo compound such as 2,2'-azobis(2,4-dimethylvaleronitrile), azobis(isobutyronitrile) and 2,2'-azobis(4-methoxy-2,4-dimethylvaleronitrile). Of them, an organic peroxide is preferably used as the oil-soluble polymerization initiator, from the point of view that the dielectric property of the hollow particles is easily improved.

With respect to 100 parts by mass of the polymerizable monomer in the mixture liquid, the content of the polymerization initiator is preferably from 0.1 parts by mass to 10 parts by mass, more preferably from 0.5 parts by mass to 7 parts by mass, and still more preferably from 1 part by mass to 5 parts by mass. When the content of the polymerization initiator is equal to or more than the lower limit value, a polymerization reaction can progress sufficiently. When the content of the polymerization initiator is equal to or less than the upper limit value, the oil-soluble polymerization initiator is less likely to remain after the end of the polymerization reaction, and an unexpected side reaction is less likely to progress.

### (D) Dispersion stabilizer

The dispersion stabilizer is an agent for dispersing the droplets of the monomer composition in the aqueous medium in the suspension step. As the dispersion stabilizer, examples include, but are not limited to, an inorganic dispersion stabilizer and a surfactant. In the present disclosure, an inorganic dispersion stabilizer is preferably used as the dispersion stabilizer, from the point of view that the particle diameter of the droplets can be easily controlled in the suspension, and the particle size distribution of the obtained hollow particles can be sharp, and that an excessive decrease in the shell thickness is suppressed, and a decrease in the strength of the hollow particles is suppressed.

As the inorganic dispersion stabilizer, examples include, but are not limited to, inorganic compounds including a sulfate such as barium sulfate and calcium sulfate; a carbonate such as barium carbonate, calcium carbonate and magnesium carbonate; a phosphate such as calcium phosphate; a metal oxide such as aluminum oxide and titanium oxide; a metal hydroxide such as aluminum hydroxide, magnesium hydroxide, calcium hydroxide, barium hydroxide and iron (II) hydroxide; and silicon dioxide. These inorganic dispersion stabilizers may be used alone or in combination of two or more.

As the inorganic dispersion stabilizer, a sparingly water-soluble inorganic dispersion stabilizer is preferably used. As used herein, "sparingly water-soluble" is preferably such that the solubility in 100 g of water is 0.5 g or less.

As the inorganic dispersion stabilizer, a metal hydroxide is preferred, and magnesium hydroxide is more preferred.

In the present disclosure, the sparingly water-soluble inorganic dispersion stabilizer is particularly preferably used in the form of colloidal particles being dispersed in the aqueous medium, that is, in the form of a colloidal dispersion containing the sparingly water-soluble, inorganic dispersion stabilizer colloidal particles. Accordingly, the inorganic dispersion stabilizer can be easily removed by the washing step described below. As a result, the aqueous dispersion of the hollow particles can easily obtain a pH of 6.5 or more and 7.5 or less and a conductivity of 50 µS/cm or less.

The colloidal dispersion containing the sparingly water-soluble inorganic dispersion stabilizer colloidal particles can be prepared by, for example, reacting at least one selected from the group consisting of alkali metal hydroxide salts and alkaline earth metal hydroxide salts with a water-soluble polyvalent metal salt, which is not an alkaline earth metal hydroxide salt, in the aqueous medium.

As the alkali metal hydroxide salts, examples include, but are not limited to, lithium hydroxide, sodium hydroxide and potassium hydroxide. As the alkaline earth metal hydroxide salts, examples include, but are not limited to, barium hydroxide and calcium hydroxide.

The water-soluble polyvalent metal salt is only required to be a water-soluble polyvalent metal salt other than compounds corresponding to the above-mentioned alkaline earth metal hydroxide salts. As the polyvalent metal salt, examples include, but are not limited to, magnesium metal salts such as magnesium chloride, magnesium phosphate and magnesium sulfate; calcium metal salts such as calcium chloride, calcium nitrate, calcium acetate and calcium sulfate; aluminum metal salts such as aluminum chloride and aluminum sulfate; barium salts such as barium chloride, barium nitrate and barium acetate; and zinc salts such as zinc chloride, zinc nitrate and zinc acetate. Among them, magnesium metal salts, calcium metal salts and aluminum metal salts are preferred; magnesium metal salts are more preferred; and magnesium chloride is particularly preferred.

The method for reacting the water-soluble polyvalent metal salt with the at least one selected from the group consisting of alkali metal hydroxide salts and alkaline earth metal hydroxide salts in the aqueous medium, is not particularly limited. For example, an aqueous solution of the water-soluble polyvalent metal salt may be mixed with an aqueous solution of the at least one selected from the group consisting of alkali metal hydroxide salts and alkaline earth metal hydroxide salts.

Also, colloidal silica may be used as the colloidal dispersion containing the sparingly water-soluble inorganic dispersion stabilizer colloidal particles.

The content of the dispersion stabilizer is not particularly limited. With respect to the total mass (100 parts by mass) of the polymerizable monomer and the hydrophobic solvent, the content of the dispersion stabilizer is preferably from 0.5 parts by mass to 15 parts by mass, and more preferably from 1 part by mass to 10 parts by mass. When the content of the dispersion stabilizer is equal to or more than the lower limit value, the droplets of the monomer composition can be sufficiently dispersed in the suspension so that they do not join together. On the other hand, when the content of the dispersion stabilizer is equal to or less than the upper limit value, an increase in the viscosity of the suspension is prevented in the formation of the droplets, and a problem such that a droplet forming machine is clogged with the suspension, can be avoided.

With respect to 100 parts by mass of the aqueous medium, the content of the dispersion stabilizer is preferably from 0.5 parts by mass to 15 parts by mass, and more preferably from 0.5 parts by mass to 10 parts by mass.

In the production of the hollow particles of the present disclosure, it is preferable not to use the surfactant as a dispersion stabilizer.

In the present disclosure, the surfactant is a compound containing both a hydrophilic group and a hydrophobic group per molecule. The surfactant includes a known surfactant such as an ionic surfactant and a non-ionic surfactant, and a compound that is generally used as a surfactant, such as a polymer compound which exerts a dispersion effect, such as polyvinyl alcohol. The solubility of the surfactant in water at 25°C is generally 1 g/L or more.

As the ionic surfactant, examples include, but are not limited to, an anionic surfactant, a cationic surfactant and an amphoteric surfactant.

As the anionic surfactant, examples include, but are not limited to, carboxylate such as alkali metal salt of higher fatty acid; sulfate such as higher alcohol sulfate and higher alkyl ether sulfate; sulfonate such as alkylbenzene sulfonate, alkyl sulfonate and paraffin sulfonate; and phosphate such as higher alcohol phosphate.

As the cationic surfactant, examples include, but are not limited to, quaternary ammonium salt such as alkyltrimethylammonium salt.

As the amphoteric surfactant, examples include, but are not limited to, an amino acid-type amphoteric surfactant such as higher alkyl aminopropionate, and a betaine-type amphoteric surfactant such as higher alkyl dimethyl betaine and higher alkyl dihydroxyethyl betaine.

As the non-ionic surfactant, examples include, but are not limited to, those that can be used in the aqueous dispersion of the hollow particles for pH and conductivity measurements.

As the polymer compound usable as the surfactant, which exerts a dispersion effect, examples include, but are not limited to, a polymer compound containing both a hydrophilic group and a hydrophobic group, such as polyvinyl alcohol, polyvinylpyrrolidone, methyl cellulose, ethyl cellulose, polyacrylic acid, polyacrylimide, polyethylene oxide and a poly(hydroxystearic acid-g-methyl methacrylate-co-methacrylic acid) copolymer.

The molecular weight of the surfactant is not particularly limited, and it is generally less than 3000.

### (E) Aqueous medium

In the present disclosure, the term "aqueous medium" means a medium selected from the group consisting of water, a hydrophilic solvent and a mixture thereof.

When a mixture of water and a hydrophilic solvent is used, from the viewpoint of forming the droplets of the monomer composition, it is important that the polarity of the entire mixture is not too low. In this case, for example, the mass ratio between water and the hydrophilic solvent (water : hydrophilic solvent) may be set to 99:1 to 50:50.

In the present disclosure, the hydrophilic solvent is not particularly limited, as long as it is one that mixes with water sufficiently and does not develop phase separation. As the hydrophilic solvent, examples include, but are not limited to, alcohols such as methanol and ethanol; tetrahydrofuran (THF); and dimethyl sulfoxide (DMSO).

The content of the aqueous medium is not particularly limited. From the viewpoint of controlling the particle diameter and void ratio of the hollow particles in the preferred ranges described below, with respect to 100 parts by mass of the polymerizable monomer contained in the mixture liquid, the content of the aqueous medium is, as the lower limit thereof, preferably 200 parts by mass or more, more preferably 400 parts by mass or more, and still more preferably 600 parts by mass or more. The content is, as the upper limit thereof, preferably 1000 parts by mass or less, and more preferably 800 parts by mass or less.

The mixture liquid may further contain other materials that are different from the above-mentioned materials (A) to (E), to the extent that does not impair the effects of the present disclosure.

The mixture liquid is obtained by mixing the above-mentioned materials and other materials as needed, appropriately stirring the mixture, etc. In the mixture liquid, an oil phase containing lipophilic materials such as (A) the polymerizable monomer, (B) hydrophobic solvent and (C) the polymerization initiator is dispersed with a size of a particle diameter of approximately several millimeters in an aqueous phase containing (D) the dispersion stabilizer, (E) the aqueous medium, etc. The dispersion state of these materials in the mixture liquid can be observed with the naked eye, depending on the types of the materials.

In the mixture liquid preparation step, the mixture liquid may be obtained by simply mixing the above-mentioned materials and other materials as needed, appropriately stirring the mixture, etc. From the point of view that the shell can be easily uniform, it is preferable to prepare the mixture liquid by separately preparing the oil phase, which contains the polymerizable monomer, the hydrophobic solvent and the polymerization initiator, and the aqueous phase, which contains the dispersion stabilizer and the aqueous medium, in advance, and then mixing the phases together. In the present disclosure, a colloidal dispersion in which a sparingly water-soluble inorganic dispersion stabilizer is dispersed in the form of colloidal particles in the aqueous medium, can be preferably used as the aqueous phase.

As just described, by separately preparing the oil phase and the aqueous phase in advance and then mixing them, hollow particles such that the composition of the shell portion is uniform, can be produced. Also, the particle diameter of the hollow particles can be easily controlled.

### (2) Suspension step

The suspension step includes suspending the above-described mixture liquid to prepare a suspension in which droplets of a monomer composition containing the hydrophobic solvent are dispersed in the aqueous medium.

The suspension method for forming the droplets of the monomer composition is not particularly limited, and a known suspension method can be employed. A disperser is used to prepare the suspension. As the disperser, a horizontal or vertical in-line disperser such as MILDER (product name, manufactured by Pacific Machinery & Engineering Co., Ltd.), CAVITRON (product name, manufactured by EUROTEC, Ltd.) and an in-line disperser manufactured by IKA (e.g., DISPAX-REACTOR (registered trademark) DRS (product name)) or an emulsifying disperser such as HOMOMIXER MARK II series (manufactured by PRIMIX Corporation) can be used.

In the suspension prepared in the suspension step, the droplets of the monomer composition containing the lipophilic materials mentioned above and having a particle diameter of approximately from 1 µm to 10 µm, are dispersed uniformly in the aqueous medium. Such droplets of the monomer composition are difficult to observe with the naked eye and can be observed with a known observation instrument such as an optical microscope.

In the suspension step, since phase separation occurs in the droplets of the monomer composition, the hydrophobic solvent with low polarity is likely to collect in the interior of the droplets. As a result, in the obtained droplets, the hydrophobic solvent is distributed in the interior thereof, and the material not containing the hydrophobic solvent is distributed at the periphery thereof.

The droplets of the monomer composition dispersed in the aqueous medium are formed by the oil-soluble monomer composition and the dispersion stabilizer surrounding the periphery of the oil-soluble monomer composition. The droplets of the monomer composition contain the oil-soluble polymerization initiator, the polymerizable monomer and the hydrophobic solvent.

The droplets of the monomer composition are minute oil droplets, and the oil-soluble polymerization initiator generates polymerization initiating radicals in the interior of the minute oil droplets. Therefore, the precursor particles having a target particle diameter can be produced without an excessive growth of the minute oil droplets.

In the suspension polymerization method using such an oil-soluble polymerization initiator, there is no opportunity for the polymerization initiator to come into contact with the polymerizable monomer dispersed in the aqueous medium. Therefore, by using the oil-soluble polymerization initiator, the subgeneration of surplus resin particles (e.g., solid particles having a relatively small particle diameter) in addition to the target resin particles having the hollow portion, can be suppressed.

### (3) Polymerization step

The polymerization step includes subjecting the suspension obtained by the suspension step to a polymerization reaction to prepare a precursor composition containing precursor particles. The precursor particles have the hollow portion surrounded by the shell which contains the resin, and they include the hydrophobic solvent in the hollow portion. The precursor particles are formed by the polymerization of the polymerizable monomer contained in the droplets of the monomer composition, and the shell of the precursor particles contains the polymer of the polymerizable monomer as the resin.

The polymerization system is not particularly limited. For example, a batch system, a semicontinuous system or a continuous system may be employed.

The polymerization temperature is not particularly limited. The polymerization temperature is generally from 40°C to 90°C. From the viewpoint of decreasing the amount of the residual unreacted polymerizable monomer, it is preferably 80°C or more.

The polymerization reaction time is generally from 1 hour to 48 hours. From the viewpoint of decreasing the amount of the residual unreacted polymerizable monomer, it is preferably 8 hours or more. The upper limit of the polymerization reaction time is preferably 36 hours or less, from the viewpoint of ease of production.

The polymerization temperature and the polymerization reaction time are preferably adjusted so that the polymerization conversion rate of the polymerizable monomer reaches 90% or more. In the present disclosure, the polymerization conversion rate is obtained by the following formula (2) using the mass of the solid content of the precursor particles obtained by the polymerization reaction and the mass of the polymerizable monomer remaining unreacted after the polymerization reaction. The mass of the unreacted polymerizable monomer can be measured by, as described below, gas chromatography (GC).

Polymerization conversion rate (% by mass) = 100 - (Mass of the unreacted polymerizable monomer / Mass of the solid content of the precursor particles) × 100 Formula (2)

By sufficiently decreasing the amount of the residual unreacted polymerizable monomer remaining after the polymerization reaction, aggregation of the hollow particles in the precursor composition is suppressed. As a result, in the below-described washing step, the metal and surfactant present on the surface of the precursor particles can be easily removed therefrom, and such hollow particles can be easily obtained, that the above-described aqueous dispersion of the hollow particles can obtain a pH of 6.5 or more and 7.5 or less and a conductivity of 50 µS/cm or less.

### (4) Washing step

The washing step includes washing the precursor particles obtained by the above-described polymerization step. The washing step may be a step to remove the dispersion stabilizer.

In the present disclosure, to adjust the pH of the aqueous dispersion of the hollow particles, which are obtained by dispersing the hollow particles with a volume of 0.35 cm³ in 100 mL of deionized water, to 6.5 or more and 7.5 or less, and the conductivity thereof to 50 µS/cm or less, the washing step is preferably carried out by the following method. First, acid or alkali is added to the precursor composition obtained by the polymerization step to dissolve the dispersion stabilizer contained in the precursor particles into the aqueous medium. At this time, when aggregation of the precursor particles is found, it is preferable to loosen the aggregation. Next, the precursor particles are separated from the aqueous medium. Then, a series of the steps of dispersing the separated precursor particles in deionized water to be reslurried and then separating the precursor particles, is repeated three times or more. Even in the case where aggregation of the precursor particles is found in the slurry obtained by the reslurrying step, it is preferable to loosen the aggregation. By such a washing step, the dispersion stabilizer present on the surface of the precursor particles can be sufficiently removed therefrom. In the present disclosure, the number of times that the precursor particles separated after the acid or alkali addition are reslurried and separated, is referred to as the "number of washing times". As described above, the number of washing times is preferably three times or more, and more preferably 4 times or more. The upper limit of the number of washing times is not particularly limited. From the viewpoint of ease of production, it may be 6 times or less, or it may be 5 times or less.

In the case of adding acid or alkali to the precursor composition, when the dispersion stabilizer used is an acid-soluble inorganic dispersion stabilizer, adding acid to the precursor composition is preferred. When the dispersion stabilizer used is an alkali-soluble inorganic dispersion stabilizer, adding alkali to the precursor composition is preferred.

When the acid-soluble inorganic dispersion stabilizer is used as the dispersion stabilizer, the pH of the precursor composition is preferably adjusted to 6.5 or less, and more preferably 6 or less, by adding acid to the precursor composition. As the added acid, an inorganic acid such as sulfuric acid, hydrochloric acid and nitric acid or an organic acid such as formic acid and acetic acid may be used. Of them, sulfuric acid is particularly preferred, due to its high dispersion stabilizer removal efficiency and small influence on production equipment.

The method for separating the precursor particles from the aqueous medium is not particularly limited. As the method, examples include, but are not limited to, a centrifugation method, a filtration method, and still-standing separation. Among them, a filtration method is preferred from the viewpoint of simplicity of the operation and high dispersion stabilizer removal efficiency. Upon the separation of the precursor particles from the aqueous medium, the precursor particles obtained by the filtration method or the like are preferably dehydrated by a known method.

The acid- or alkali-added precursor composition and the slurry obtained by dispersing the separated precursor particles in deionized water to be reslurried, are preferably in such a state, that there is no aggregation of the precursor particles. That is, it is preferable that an aggregate of the precursor particles is not found in the slurries by visual observation. To obtain the state that there is no aggregation of the precursor particles in the slurries, for example, the following are effective: performing the polymerization reaction in the above-described polymerization step until the polymerization conversion rate reaches 90% or more to decrease the amount of the residual unreacted polymerizable monomer remaining in the precursor particles, and preliminarily removing the unreacted monomer from the slurries. If the precursor particles aggregate in the slurries, it is difficult to wash the interior of the aggregate, and the dispersion stabilizer is likely to remain in the hollow particles, accordingly. Since there is no aggregation of the precursor particles in the slurries, the surface of the particles can be easily washed, and the dispersion stabilizer can be easily removed, accordingly. In addition, when there is no aggregation of the precursor particles, the speed of filtering the slurries decreases due to the large surface area of the precursor particles in the slurries, and the washing time increases. Accordingly, the dispersion stabilizer is likely to be removed.

### (5) Solvent removal step

The solvent removal step includes removing the included hydrophobic solvent from the precursor particles.

In the present disclosure, a method of removing the included hydrophobic solvent from the precursor particles in a gaseous atmosphere, which are obtained from the slurry by solid-liquid separation, or a method of removing the included hydrophobic solvent from the precursor particles in the slurry in which the precursor particles are dispersed in the aqueous medium, may be employed. The former method is advantageous in that the metal content of the obtained hollow particles can be easily reduced. The latter method is advantageous in that the amount of the residual hydrophobic solvent decreases.

The method of performing the solid-liquid separation is the same as the above-described method of separating the precursor particles from the aqueous medium.

The precursor particles subjected to the solid-liquid separation may be preliminary dried before the removal of the hydrophobic solvent. The preliminary drying may be performed by drying a component in a solid form containing the precursor particles obtained by the solid-liquid separation, by use of a drying apparatus such as a dryer and a drying appliance such as a hand dryer.

In this step, the term "in a gaseous atmosphere" includes "in an environment where no liquid component exists in the outside of the precursor particles" and "in an environment where only a very small amount of liquid component at a level that does not influence the removal of the hydrophobic solvent, exists in the outside of the precursor particles" in a strict sense. The term "in a gaseous atmosphere" can be reworded as a state where the precursor particles do not exist in a slurry, or it can be reworded as a state where the precursor particles exist in a dry powder. That is, it is important to remove the hydrophobic solvent in an environment where the precursor particles come into direct contact with the outside gas.

The method of removing the hydrophobic solvent from the precursor particles in a gaseous atmosphere, is not particularly limited, and a known method may be employed. Examples of the method include a reduced pressure drying method, a heat drying method, a flash drying method, and the combination of these methods.

Especially, in the case of using the heat drying method, the heating temperature needs to be set to more than or equal to the boiling point of the hydrophobic solvent and less than or equal to the highest temperature at which the shell structure of the precursor particles does not collapse. Accordingly, depending on the composition of the shell and the type of the hydrophobic solvent in the precursor particles, the heating temperature may be from 50°C to 200°C, may be from 70°C to 200°C, or may be from 100°C to 200°C, for example.

The hydrophobic solvent in the interior of the precursor particles is substituted with the outside gas by the drying operation in the gaseous atmosphere. As a result, the hollow particles in which the hollow portion is occupied by gas, are obtained.

The drying atmosphere is not particularly limited and may be appropriately selected depending on the intended application of the hollow particles. Possible examples of the drying atmosphere include air, oxygen, nitrogen and argon. Further, by filling the interior of the hollow particles with gas once and then performing reduced pressure drying, hollow particles in which the interior is evacuated are also temporarily obtained.

As the method of removing the included hydrophobic solvent from the precursor particles in the slurry in which the precursor particles are dispersed in the aqueous medium, examples include, but are not limited to, evaporating the hydrophobic solvent included in the precursor particles at a predetermined pressure in the slurry. More specifically, the examples include, but are not limited to, evaporating the hydrophobic solvent included in the precursor particles by introducing water vapor or inert gas such as nitrogen, argon and helium to the slurry at a predetermined pressure selected from high, normal or reduced pressures. From the viewpoint of excellent hydrophobic solvent removal efficiency, evaporating the hydrophobic solvent included in the hollow particles by introducing, at a predetermined pressure, inert gas to the slurry in which the precursor particles are dispersed, is particularly preferred.

As the method of introducing the inert gas into the slurry, for example, a method of bubbling the inert gas into the slurry is preferably used.

The temperature at the time of introducing the inert gas into the slurry is preferably a temperature equal to or more than the temperature obtained by subtracting 35°C from the boiling point of the hydrophobic solvent, more preferably a temperature equal to or more than the temperature obtained by subtracting 30°C from the boiling point of the hydrophobic solvent, and still more preferably a temperature equal to or more than the temperature obtained by subtracting 20°C from the boiling point of the hydrophobic solvent, from the viewpoint of reducing the amount of the residual hydrophobic solvent. When the hydrophobic solvent is a mixed solvent containing several types of hydrophobic solvents and it has several boiling points, the boiling point of the hydrophobic solvent in the solvent removal step is determined as the boiling point of the solvent having the highest boiling point among the solvents contained in the mixed solvent, that is, the highest boiling point of the several boiling points. The temperature at the time of introducing the inert gas into the slurry is generally set to a temperature equal to or more than the polymerization temperature of the polymerization step. The temperature at the time of introducing the inert gas into the slurry is not particularly limited, and it may be from 50°C to 100°C.

Depending on the type and amount of the hydrophobic solvent, the condition of bubbling the inert gas into the slurry is appropriately controlled so that the included hydrophobic solvent can be removed from the precursor particles. The bubbling condition is not particularly limited. For example, the inert gas may be bubbled in an amount of 1 L/min to 3 L/min for 1 hour to 72 hours.

By the method of introducing the inert gas into the slurry, a slurry of the hollow particles including the inert gas is obtained. The slurry is subjected to solid-liquid separation to obtain hollow particles, and the obtained hollow particles are dried for removal of residual water, thereby obtaining the hollow particles in which the hollow portion is occupied by gas.

### (6) Others

In addition to the steps (1) to (5) mentioned above, a particle interior substitution step may be added, for example.

The particle interior substitution step includes substituting the gas or liquid in the interior of the hollow particles with another gas or liquid. By such substitution, the environment of the interior of the hollow particles can be changed; molecules can be selectively confined in the interior of the hollow particles; or the chemical structure of the interior of the hollow particles can be modified in accordance with the intended application.

### 2. Hollow particles

The hollow particles of the present disclosure are particles comprising a resin-containing shell (outer shell) and a hollow portion surrounded by the shell.

In the present disclosure, the term "hollow portion" means a hollow space clearly distinguished from the shell of hollow particles formed from a resin material. The shell of the hollow particles may have a porous structure. In this case, the hollow portion has a size that is clearly distinguishable from many minute spaces uniformly dispersed in the porous structure. From the viewpoint of dielectric property and so on, the hollow particles of the present disclosure preferably have a solid shell.

The hollow portion of the hollow particles can be determined by, for example, SEM observation of a cross section of the particles or TEM observation of the particles as they are.

From the viewpoint of exerting excellent dielectric property, the hollow portion of the hollow particles of the present disclosure is preferably filled with gas such as air.

In the hollow particles of the present disclosure, from the viewpoint of decreasing the dielectric dissipation factor of the hollow particles and improving the performance stability of the hollow particles in high-humidity environment, the content of the surfactant present on the surface of the hollow particles is preferably 200 ppm or less, more preferably 100 ppm or less, and still more preferably 50 ppm or less. By not using the surfactant as the dispersion stabilizer in the process of producing the hollow particles described above, the content of the surfactant present on the surface of the hollow particles can be adjusted to less than the measurement limit value.

In the present disclosure, the content of the surfactant present on the surface of the hollow particles is the ratio of the mass of the surfactant present on the surface of the hollow particles to the mass of the hollow particles. The surfactant present on the surface of the hollow particles can be extracted by, for example, ultrasonication of the hollow particles in water. The type and mass of the surfactant extracted in water can be specified by the peak position and peak intensity of a ¹H-NMR spectrum. In this method, the measurement limit of the content of the surfactant present on the surface of the hollow particles is generally 0.05 ppm.

In the hollow particles of the present disclosure, since the pH of the aqueous dispersion of the hollow particles described above can easily fall within a range of 6.5 or more and 7.5 or less and the conductivity thereof can easily be 50 µS/cm or less, the metal content in the hollow particles is preferably 700 ppm or less, more preferably 400 ppm or less, and still more preferably 200 ppm or less. The metal content in the hollow particles is the ratio of the total mass of the metal components contained in the hollow particles to the mass of the hollow particles. To adjust the metal content in the hollow particles to the upper limit value or less, for example, it is preferable to use a metal-free polymerization initiator, to use deionized water as the aqueous medium, to carry out the above-mentioned washing process in the production of the hollow particles, or to employ a method for removing the hydrophobic solvent from the precursor particles in a gaseous atmosphere, in the solvent removal step in the production of the hollow particles.

The hollow particles of the present disclosure may contain the metal as long as the pH of the aqueous dispersion of the hollow particles described above can be 6.5 or more and 7.5 or less and the conductivity thereof can be 50 µS/cm or less. The metal content in the hollow particles of the present disclosure may be less than the measurement limit, but it may be 50 ppm or more, may be 80 ppm or more, may be 100 ppm or more, may be 120 ppm or more, or may be 150 ppm or more.

The metal content in the hollow particles can be measured by ICP atomic emission spectroscopy. The metal species can be specified by X-ray fluorescence spectrometry (XRF). In this method, the measurement limit of the metal content in the hollow particles is generally 5 ppm.

The hollow particles of the present disclosure contain the polymer of the above-described polymerizable monomer as the main component of the shell, and the polymer forms the skeleton of the shell of the hollow particles. In the total solid content (100% by mass) of the shell, the content of the polymer of the polymerizable monomer is preferably 98% by mass or more, more preferably 99% by mass or more, and still more preferably 99.5% by mass or more. By adjusting the content of the polymer to equal to or more than the lower limit value, a deterioration in dielectric property, a decrease in strength, and a reduction in performance stability in high-humidity environment can be suppressed in the hollow particles.

From the point of view that the pH of the aqueous dispersion of the hollow particles described above can easily fall within a range of 6.5 or more and 7.5 or less and the conductivity thereof can easily be 50 µS/cm or less, in the hollow particles of the present disclosure, the content of the polymerizable monomer remaining unreacted, is preferably 1.5% by mass or less, more preferably 1.0% by mass or less, still more preferably 0.8% by mass or less, even more preferably 0.5% by mass or less, and particularly preferably 0.15% by mass or less, in the total solid content (100% by mass) of the shell.

The content of the residual unreacted polymerizable monomer can be obtained by, for example, gas chromatography measurement of the solution obtained by extracting the residual unreacted polymerizable monomer from the hollow particles.

When the content of the residual unreacted polymerizable monomer is 1.5% by mass or less, the content of each monomer unit contained in the shell-forming polymer can be calculated from the fed amount of the polymerizable monomer.

The shell of the hollow particles of the present disclosure may further contain another material such as a polymer different from the polymer of the polymerizable monomer, to the extent that does not impair the effects of the present disclosure.

In general, the composition of the polymer contained in the hollow particles of the present disclosure corresponds to the composition of the above-described polymerizable monomer.

In 100% by mass of all the monomer units of the polymer, the content of the crosslinkable monomer unit is preferably 60% by mass or more, more preferably 70% by mass or more, and still more preferably 80% by mass or more, from the point of view that the pressure resistance of the hollow particles is increased, and the hollow particles can easily keep a high void ratio. When the pressure resistance of the hollow particles is excellent, the hollow particles can keep a high void ratio even after they are added to various kinds of materials. Accordingly, effects such as a permittivity decreasing effect and a dielectric dissipation factor decreasing effect can be easily exerted by the hollow particles. On the other hand, since the dielectric dissipation factor of the hollow particles is likely to decrease, the content of the crosslinkable monomer unit is preferably 96% by mass or less, more preferably 90% by mass or less, and still more preferably 85% by mass or less. In the shell in which the content of the crosslinkable monomer unit is equal to or less than the upper limit value and the crosslinkable monomer unit is contained in combination with a non-crosslinkable monomer unit, as the content of the non-crosslinkable monomer unit increases, the number of double bonds remained without the contribution to the reaction, decreases. Accordingly, the number of components that make a molecular motion when an electric field is applied, decreases. It is estimated that energy loss is thus reduced, thereby decreasing the dielectric dissipation factor of the hollow particles.

From the viewpoint of improving the dielectric property of the hollow particles, in 100% by mass of all the monomer units of the polymer, the content of the hydrocarbon monomer unit is preferably more than 50% by mass, more preferably 70% by mass or more, still more preferably 90% by mass or more, and even more preferably 95% by mass or more. The polymer may be composed of the hydrocarbon monomer unit. As the proportion of the hydrocarbon monomer unit in the polymer increases, the relative permittivity and dielectric dissipation factor of the hollow particles tend to decrease. In recent years, for the purpose of transmitting large volumes of information in information processing by electronic devices, there is an effort to increase a transmission frequency, and there is a demand for a technique to decrease a permittivity and a dielectric dissipation factor, which is applicable to high-frequency transmission. By increasing the content of the hydrocarbon monomer unit in the polymer, the hollow particles in which the relative permittivity and dielectric dissipation factor are sufficiently decreased even at a high frequency of about 10 GHz, are obtained.

From the viewpoint of achieving excellent pressure resistance while improving the dielectric property of the hollow particles, the hydrocarbon monomer unit preferably contains at least a crosslinkable hydrocarbon monomer unit. Particularly from the viewpoint of improving the dielectric property of the hollow particles, the hydrocarbon monomer unit preferably contains a crosslinkable hydrocarbon monomer unit in combination with a non- crosslinkable hydrocarbon monomer unit.

The effects of decreasing the dielectric dissipation factor and improving the performance stability in high-humidity environment, which are exerted by the hollow particles of the present disclosure since the above-described aqueous dispersion of the hollow particles has a pH of 6.5 or more and **7.5** or less and a conductivity of 50 µS/cm or less, are particularly effectively exerted when the content of the hydrocarbon monomer unit in the polymer constituting the shell is more than 50% by mass, and they are much more effectively exerted when the hydrocarbon monomer unit contains a crosslinkable hydrocarbon monomer unit in combination with a non-crosslinkable hydrocarbon monomer unit.

The dielectric dissipation factor of the hollow particles of the present disclosure at a frequency of 10 GHz is preferably 1.00 × 10⁻³ or less, more preferably 9.00 × 10⁻⁴ or less, still more preferably 6.00 × 10⁻⁴ or less, and even more preferably 4.00 × 10⁻⁴ or less. The lower limit thereof is not particularly limited, and it may be 1.00 × 10⁻⁴ or more, for example.

The relative permittivity of the hollow particles of the present disclosure at a frequency of 10 GHz is preferably 1.40 or less, more preferably 1.37 or less, and still more preferably 1.35 or less. The lower limit thereof is not particularly limited, and it may be 1.00 or more, for example.

In the present disclosure, the relative permittivity and dielectric dissipation factor of the hollow particles are measured by use of a perturbation-type measuring device.

The void ratio of the hollow particles of the present disclosure is 50% or more. It is preferably 60% or more, more preferably 65% or more, and still more preferably 70% or more. When the void ratio is equal to or more than the lower limit value, the hollow particles are excellent in dielectric property, and they are also excellent in lightness in weight, heat resistance, heat insulation property, and so on. The upper limit of the void ratio of the hollow particles is not particularly limited. From the viewpoint of suppressing a decrease in the strength of the hollow particles and improving the collapse-resistance of the hollow particles, it is preferably 90% or less, more preferably 85% or less, and still more preferably 80% or less.

The void ratio of the hollow particles can be calculated from the apparent density D₁ and true density D₀ of the hollow particles.

A method for measuring the apparent density D₁ of the hollow particles is as follows. First, approximately 30 cm³ of the hollow particles are introduced into a measuring flask with a volume of 100 cm³, and the mass of the introduced hollow particles is precisely weighed. Next, the measuring flask in which the hollow particles are introduced, is precisely filled with isopropanol up to the marked line while care is taken so that air bubbles do not get in. The mass of the isopropanol added to the measuring flask is precisely weighed, and the apparent density D₁ (g/cm³) of the hollow particles is calculated by the following formula (I). Apparent density D1 = [Mass of the hollow particles]/(100-[Mass of the isopropanol]/[Specific gravity of the isopropanol at the measuring temperature])

The apparent density D₁ is equivalent to the specific gravity of the whole hollow particle in the case where the hollow portion is regarded as a part of the hollow particle.

A method for measuring the true density D₀ of the hollow particles is as follows. The hollow particles are pulverized in advance; approximately 10 g of the pulverized hollow particles are introduced into a measuring flask with a volume of 100 cm³; and the mass of the introduced pulverized particles is precisely weighed. After that, similarly to the measurement of the apparent density mentioned above, isopropanol is added to the measuring flask; the mass of the isopropanol is precisely weighed; and the true density D₀ (g/cm³) of the hollow particles is calculated by the following formula (II). True density D0 = [Mass of the pulverized hollow particles]/(100-[Mass of the isopropanol]/[Specific gravity of the isopropanol at the measuring temperature])

The true density D₀ is equivalent to the specific gravity of the shell portion alone of the hollow particle. As is clear from the measurement method mentioned above, when calculating the true density D₀, the hollow portion is not regarded as a part of the hollow particle.

The void ratio (%) of the hollow particles is calculated by the following formula (III) from the apparent density D₁ and the true density D₀. Void ratio (%) = 100-(Apparent density D1/True density D0)×100

In the present disclosure, the lower limit of the volume average particle diameter of the hollow particles is preferably 1.0 µm or more, more preferably 1.5 µm or more, and still more preferably 2.0 µm or more. On the other hand, the upper limit of the volume average particle diameter of the hollow particles is preferably 10.0 µm or less, more preferably 8.0 µm or less, still more preferably 6.0 µm or less, and even more preferably 4.0 µm or less. When the volume average particle diameter of the hollow particles is equal to or more than the lower limit value, shell thickness non-uniformity is suppressed, and a uniform shell is easily formed. In addition, the hollow particles are less likely to collapse, and they obtain high mechanical strength. When the volume average particle diameter of the hollow particles is equal to or less than the upper limit value, since the particle diameter is sufficiently small, the hollow particles are preferably used as a substrate material such as an electronic circuit board, and they can be added to thin small substrates.

The shape of the hollow particles of the present disclosure is not particularly limited, as long as the hollow portion is formed in the interior. As the shape, examples include, but are not limited to, a spherical shape, an ellipsoidal shape and an irregular shape. Among them, a spherical shape is preferable in terms of ease of production, pressure resistance and so on.

The hollow particles of the present disclosure may have one or two or more hollow portions. From the viewpoint of maintaining good balance between the high void ratio and the mechanical strength and from the viewpoint of improving the dielectric property, the hollow particles preferably have only one hollow portion.

When the hollow particles of the present disclosure are particles having only one hollow portion, the hollow particles of the present disclosure may contain, as impurities, a small amount of hollow particles having two or more hollow portions or a small amount of particles not having a hollow portion. In the hollow particles of the present disclosure, the percentage of the number of the particles having only one hollow portion is preferably 90% or more, and more preferably 95% or more.

The shell of the hollow particles of the present disclosure and, when the hollow particles have two or more hollow portions, a partition separating the adjacent hollow portions from each other may be porous. From the viewpoint of improving the dielectric property, the shell and the partition are preferably solid.

The average circularity of the hollow particles of the present disclosure may be from 0.950 to 0.995.

An example of the image of the shape of the hollow particles of the present disclosure, is a bag made of a thin film and inflated with gas. A cross-section of the bag is like the hollow particle 10 shown in the diagram (5) of FIG. 1. In this example, one thin film is provided on the outside, and the interior is filled with gas.

The shape of the particles can be determined by SEM or TEM, for example.

In the hollow particles of the present disclosure, from the viewpoint of dielectric property and pressure resistance, the percentage of particles having a circularity of 0.85 or less is preferably small. The particles having a circularity of 0.85 or less are typically cracked particles or deformed particles such as dented particles. In the present disclosure, such particles may be referred to as "irregular-shaped particles". Such irregular-shaped hollow particles have a low void ratio compared to spherical hollow particles; therefore, they are poor in dielectric property. Accordingly, the dielectric property of the hollow particles can be improved by decreasing the percentage of the irregular-shaped particles included in the hollow particles.

Also, such irregular-shaped particles are poor in pressure resistance compared to spherical particles, since external pressure is likely to be locally applied thereto. In addition, the irregular-shaped particles have the following problem: compared to spherical particles, the irregular-shaped particles are poor in dispersibility since they are likely to aggregate when dispersed in the matrix resin. When the irregular-shaped particles are dispersed in the matrix resin, aggregates are likely to be formed; external pressure is likely to be applied to the aggregates; and the pressure resistance further deteriorates, accordingly. Therefore, the dispersibility and pressure resistance of the hollow particles can be improved by decreasing the percentage of the irregular-shaped particles included in the hollow particles.

The hollow particles of the present disclosure may contain, as impurities, small amounts of particles having a low circularity, such as cracked or deformed particles. In 100% by mass of the hollow particles of the present disclosure, the percentage of the particles having a circularity of 0.85 or less is preferably 10% by mass or less, more preferably 7% by mass or less, still more preferably 5% by mass or less, even more preferably 4% by mass or less, and particularly preferably 3% by mass or less.

The term "circularity" is defined as a value obtained by dividing the equivalent circular area diameter which is the diameter of a circle having the same area as the projected image of a particle, by the equivalent circular perimeter diameter which is the diameter of a circle having the same perimeter as the projected image of the particle. The circularity is 1 when the hollow particles are perfectly spherical, and it gets smaller as the surface shape of the hollow particles becomes more complex.

In the present disclosure, the circularity is measured by use of a flow particle image analyzer at an image resolution of 0.185 um/pixel.

As the flow particle image analyzer, for example, IF-3200 (product name, manufactured by JASCO International Co., Ltd.) is preferably used. The measurement sample is prepared by, for example, performing a dispersion treatment of a mixture liquid, which is obtained by adding 0.10 g to 0.12 g of the hollow particles to an aqueous solution of linear alkylbenzene sulfonate (concentration 0.3%), in an ultrasonic cleaner for 5 minutes.

The average circularity is the average of the circularities of randomly selected 1000 to 3000 particles.

The particle size distribution (volume average particle diameter (Dv)/number average particle diameter (Dn)) of the hollow particles may be 1.1 or more and 2.5 or less, for example. When the particle size distribution is 2.5 or less, hollow particles such that performance slightly vary between the hollow particles, can be obtained. Also when the particle size distribution is 2.5 or less, a product having uniform thickness can be produced in the case of producing, for example, a sheet-shaped resin molded body mixed with the hollow particles of the present disclosure.

The volume average particle diameter (Dv) and number average particle diameter (Dn) of the hollow particles can be found as follows, for example. The particle diameter of each of the hollow particles is measured with a particle size distribution measuring apparatus; the number average and volume average of the particle diameters are calculated; and the obtained values can be used as the number average particle diameter (Dn) and volume average particle diameter (Dv) of the hollow particles. The particle size distribution is found by dividing the volume average particle diameter by the number average particle diameter.

In the present disclosure, the thermal decomposition initiation temperature of the hollow particles is preferably from 150°C to 400°C, and more preferably from 200°C to 350°C. When the thermal decomposition initiation temperature is in the range, the hollow particles are excellent in heat resistance.

In the present disclosure, the thermal decomposition initiation temperature of the hollow particles can be measured as a 5% weight reduction temperature, using a TG-DTA device in an air atmosphere, in the conditions of an air flow rate of 230 mL/min and a temperature increase rate of 10°C/min.

### 3. Applications of the hollow particles

As the applications of the hollow particles of the present disclosure, examples include, but are not limited to, additives for the following: materials such as a low dielectric material, a heat insulation material, a sound insulation material and a light reflective material, which are used in various kinds of fields such as the automotive field, the electronics field, the electric field, the architecture field, the aviation field and the space field; food containers; footwears such as sports shoes and sandals; components of household appliances; components of bicycles; stationery supplies; tools; filaments of 3D printers; and floating buoyant materials such as syntactic foam. Especially because the hollow particles of the present disclosure are low in dielectric dissipation factor, excellent in dielectric property and excellent in performance stability in high-humidity environment, they are preferably used as a highly-reliable material in the electric or electronics field. For example, the hollow particles of the present disclosure are preferably used as an electronic circuit board material. More specifically, by incorporating the hollow particles of the present disclosure in the insulating resin layer of an electronic circuit board, the dielectric dissipation factor of the insulating resin layer can be decreased, and a failure such as ion migration in high humidity environment can be suppressed.

Also, the hollow particles of the present disclosure are preferably used as an additive used in semiconductor materials such as an interlayer insulation material, a dry film resist, a solder resist, a bonding wire, a magnet wire, a semiconductor encapsulating material, an epoxy encapsulating material, a molded underfill material, an underfill material, a die bonding paste, a buffer coating material, a copper-clad laminate, and a flexible substrate. Also, the hollow particles of the present disclosure are preferably used as an additive used in semiconductor materials for use in a high frequency device module, an antenna module, an automotive radar and so on. Of them, the hollow particles of the present disclosure are particularly preferable as an additive used in semiconductor materials such as an interlayer insulation material, a solder resist, a magnet wire, a semiconductor encapsulant, an epoxy encapsulating material, an underfill material, a buffer coating material, a copper-clad laminate and a flexible substrate. Also, the hollow particles of the present disclosure are particularly preferable as an additive used in semiconductor materials for use in a high frequency device module, an antenna module, an automotive radar and so on. The hollow particles of the present disclosure are applicable to not only semiconductor materials but also various kinds of electronic materials.

Also, the hollow particles of the present disclosure are useful as an additive for insulating resin sheets that are used for the production of electronic parts such as a printed circuit board. An insulating resin sheet containing the hollow particles of the present disclosure can be produced as follows, for example: a resin composition is prepared by mixing the hollow particles of the present disclosure and a thermoplastic resin, thermosetting resin, thermoplastic elastomer, or a mixture thereof, and the resin composition is molded into a sheet by applying the composition to one or both surfaces of a sheet-shaped substrate and drying the applied composition, by extrusion molding of the composition, by transferring the composition, etc., thereby producing the insulating resin sheet. When the resin or elastomer contained in the insulating resin sheet is adhesive, the insulating resin sheet can be used as an adhesive sheet. More specifically, it can be used as a bonding sheet, for example. A bonding sheet is a material for forming insulating adhesive layers which are used to attach a conductor layer and an organic insulating layer in the production of a multi-layer printed circuit board.

Since the hollow particles of the present disclosure sufficiently contains the crosslinkable monomer unit in the shell, they have excellent strength. Accordingly, the hollow particles of the present disclosure are less likely to collapse when mixed and kneaded with other materials and even when molded after mixing and kneading with other materials. When they are added to a molded body, they exert excellent effects as a permittivity decreasing material, a weight reducing material, a heat insulation material, an acoustic insulation material, a damping material and so on. Accordingly, the hollow particles of the present disclosure are suitable as an additive for molded bodies. For example, the hollow particles can be used as an additive for resin molded bodies.

As the resin mixed with the hollow particles of the present disclosure, that is, as the matrix resin, examples include, but are not limited to, a thermoplastic or thermosetting resin such as polyethylene, polypropylene, polyvinyl chloride, polystyrene, polyurethane, epoxy resin, acrylonitrile-butadiene-styrene (ABS) resin, acrylonitrile-styrene (AS) resin, poly(meth)acrylate, polycarbonate, polyamide, polyimide, polyphenylene ether, polyphenylene sulfide, polyester, polytetrafluoroethylene, maleimide resin, bismaleimide triazine resin, liquid crystalline polyester resin, phenolic resin, vinyl ester resin, unsaturated polyester resin, cyanate ester resin, polyetherketoneketone resin and polyetherimide resin.

In a resin molded body required to have a low dielectric dissipation factor, an insulation resin is preferably used as the matrix resin, such as epoxy resin, thermosetting modified polyphenylene ether resin, thermosetting polyimide resin, silicon resin, benzoxazine resin, melamine resin, urea resin, allyl resin, phenolic resin, unsaturated polyester resin, polyurethane resin and aniline resin.

In the case of using epoxy resin as the matrix resin, preferably, a curing agent (e.g., an amine, an acid anhydride and an imidazole), a curing accelerator or a catalyst is appropriately added to the epoxy resin.

Also, the hollow particles of the present disclosure can be contained as a filler in a fiber reinforced molded body formed by use of reinforcing fibers and resin. The reinforcing fibers are not particularly limited. As the reinforcing fibers, examples include, but are not limited to, organic or inorganic fibers such as carbon fibers, glass fibers, aramid fibers and polyethylene fibers.

The hollow particles of the present disclosure have a high void ratio, are less likely to collapse, and have high heat resistance. Accordingly, the hollow particles have heat insulation properties and shock-absorbing properties (cushioning properties) required of an under-coating material, and they also have heat resistance in line with thermal paper uses. Further, the hollow particles of the present disclosure are useful as a plastic pigment that is excellent in gloss, hiding power, etc.

A useful component such as a perfume, a medicine, an agricultural chemical and an ink component can be enclosed in the interior of the hollow particles of the present disclosure by a means such as immersion treatment or depressurized or pressurized immersion treatment. Accordingly, the hollow particles in which such a useful component is enclosed, can be used for various applications in accordance with the component contained in the interior.

Also, the hollow particles of the present disclosure are suitable as a rust retardant. Since the hollow particles of the present disclosure are also useful as an additive for decreasing conductivity, for example, a coating material containing the hollow particles of the present disclosure can be used as a rust-resistant coating material (such as a coating primer and a lubricating coating material) for increasing the anticorrosivity and rust resistance of steel and so on. A rust-resistant additive may be included in the hollow particles added to rust-resistant coating materials.

Hereinafter, the resin composition and resin molded body of the present disclosure will be described in more detail, both of which contain the hollow particles of the present disclosure.

### 4. Resin composition

The resin composition of the present disclosure contains the hollow particles of the present disclosure and a matrix resin.

In general, the resin composition of the present disclosure is used as a molding material for the resin molded body described below. For example, the resin composition may be in the form of liquid or pellets, or it may be a prepreg.

As the resin composition in the form of liquid, examples include, but are not limited to, a liquid resin composition containing a liquid matrix resin before being subjected to curing reaction, and a liquid resin composition obtained by dissolving or dispersing components in a solvent. The liquid matrix resin before being subjected to curing reaction and the matrix resin dissolved or dispersed in a solvent may be thermosetting or thermoplastic resin. Also, the liquid resin composition may be a resin composition liquefied by melting the matrix resin thereinto. The prepreg can be obtained by, for example, impregnating a substrate with the liquid resin composition and drying them. As the resin composition in the form of pellets, examples include, but are not limited to, a pelletized resin composition obtained by melt-kneading a resin composition containing a thermoplastic matrix resin and the hollow particles and then pelletizing the resin composition when solidified by cooling.

As described above, the hollow particles of the present disclosure are hollow particles in which the dielectric dissipation factor is decreased, and the performance stability in high-humidity environment is improved. In a resin composition and a resin molded body both of which contain conventional hollow particles, compared to the case of not containing hollow particles, the performance stability in high-humidity environment tends to decrease. Meanwhile, the resin composition and resin molded body of the present disclosure, both of which contain the hollow particles of the present disclosure, are those in which, because of containing the hollow particles of the present disclosure, a reduction in the performance stability in high-humidity environment is suppressed, while the dielectric dissipation factor is decreased.

As the matrix resin contained in the resin composition of the present disclosure, examples include, but are not limited to, the same resin as the resin mixed with the hollow particles of the present disclosure. The details are as described below.

For example, the matrix resin contained in the resin composition of the present disclosure may be a curable resin such as a thermosetting resin, a photocurable resin and a room temperature curable resin, or it may be a thermoplastic resin or the like.

Also, the matrix resin contained in the resin composition of the present disclosure is not particularly limited. The matrix resin may be an unreacted monomer, prepolymer or macromonomer; it may be a polymer; or it may be a precursor of a cured resin, such as a polyamic acid. The matrix resin contained in the resin composition of the present disclosure may function as a binder when cured by, for example, heating or light irradiation, or when cured by use of a curing agent, a polymerization initiator, a catalyst or the like.

As the thermosetting resin, a known thermosetting resin may be used, and it is not particularly limited. As the thermosetting resin, examples include, but are not limited to, phenolic resin, melamine resin, urea resin, unsaturated polyester resin, epoxy resin, polyurethane resin, silicon resin, alkyd resin, thermosetting modified polyphenylene ether resin, thermosetting polyimide resin, benzoxazine resin, allyl resin, aniline resin, maleimide resin, bismaleimide triazine resin, liquid crystalline polyester resin, vinyl ester resin, unsaturated polyester resin, cyanate ester resin, polyetherketoneketone resin, polyetherimide resin, and precursors of these resins before curing. These thermosetting resins may be used alone or in combination of two or more.

As the room temperature curable resin, examples include, but are not limited to, an adhesive that is curable at room temperature by addition of a catalyst, such as an epoxy adhesive, a silicone adhesive and an acrylic adhesive.

As the thermoplastic resin, examples include, but are not limited to, polyolefin resin, polyamide resin, polycarbonate resin, polyphenylene sulfide resin, polyether ether ketone resin, polystyrene resin, polyphenylene oxide resin and a liquid crystal polymer (LCP). As the thermoplastic resin, examples also include, but are not limited to, polyolefin (such as polypropylene and polyethylene), polyamide (such as PA6, PA66 and PA12), polyimide, polyamideimide, polyetherimide, polyetherketoneketone, polyvinyl chloride, polystyrene, poly(meth)acrylate, polycarbonate, polyvinylidene fluoride, acrylonitrile-butadiene-styrene copolymer (ABS) resin, an acrylonitrile-styrene copolymer (AS), polyphenylene ether, polyphenylene sulfide, polyester, polytetrafluoroethylene and a thermoplastic elastomer. In general, a thermoplastic elastomer has properties such that it shows rubber elasticity at ordinary temperature (25°C) and it can be plasticized and molded at high temperature. As the thermoplastic elastomer, examples include, but are not limited to, a urethane-based elastomer, a styrene-based elastomer, an olefin-based elastomer, an amide-based elastomer and an ester-based elastomer.

The matrix resin contained in the resin composition of the present disclosure is appropriately selected depending on the application of the resin composition, and it is not particularly limited. The resin composition of the present disclosure may contain one kind of matrix resin or two or more kinds of matrix resins in combination.

In the resin composition of the present disclosure, the content of the matrix resin is not particularly limited. It is preferably from 20 parts by mass to 99 parts by mass, more preferably from 30 parts by mass to 95 parts by mass, and still more preferably from 40 parts by mass to 95 parts by mass, with respect to 100 parts by mass of the total solid content of the resin composition. When the content of the matrix resin is equal to or more than the lower limit value, the moldability of the resin composition when formed into a resin molded body improves, and the mechanical strength of the resin molded body thus obtained improves. On the other hand, when the content of the matrix resin is equal to or less than the upper limit value, the hollow particles of the present disclosure can be sufficiently contained; therefore, effects such as an improvement in dielectric property can be sufficiently exerted by the hollow particles of the present disclosure.

The resin composition of the present disclosure may further contain an additive for developing a curing reaction, such as a curing agent, a curing accelerator, a curing catalyst and an initiator. They can be appropriately selected from known additives, depending on the type of the matrix resin, without particular limitation.

The content of the curing agent is not particularly limited. For example, it may be from 1 part by mass to 120 parts by mass, with respect to 100 parts by mass of the matrix resin.

The content of the curing accelerator is not particularly limited. For example, it may be from 0.01 parts by mass to 10 parts by mass with respect to 100 parts by mass of the matrix resin.

In the resin composition of the present disclosure, the content of the hollow particles is not particularly limited. With respect to 100 parts by mass of the total solid content of the resin composition, it is preferably from 1 part by mass to 70 parts by mass, more preferably from 3 parts by mass to 50 parts by mass, and still more preferably from 5 parts by mass to 40 parts by mass. When the content of the hollow particles is equal to or more than the lower limit value, effects such as an improvement in dielectric property can be sufficiently exerted by the hollow particles of the present disclosure. On the other hand, when the content of the hollow particles is equal to or less than the upper limit value, the matrix resin can be sufficiently contained in the resin composition. Accordingly, the moldability and mechanical strength of the resin composition can be improved.

The resin composition of the present disclosure may further contain reinforcing fibers. As the reinforcing fibers, examples include, but are not limited to, organic or inorganic fibers such as carbon fibers, glass fibers, aramid fibers, polyethylene fibers, cellulose nanofibers and liquid crystal polymer (LCP) fibers. The reinforcing fibers are particularly preferably at least one kind of fibers selected from the group consisting of carbon fibers and glass fibers.

The reinforcing fibers contained in the resin composition of the present disclosure may be reinforcing fibers used as the substrate of a prepreg, or they may be reinforcing fibers contained as a filler.

When the resin composition of the present disclosure contains the reinforcing fibers, with respect to the total (100 parts by mass) of the hollow particles and the matrix resin, the lower limit of the content of the reinforcing fibers is preferably 5 parts by mass or more, and more preferably 10 parts by mass or more. On the other hand, the upper limit of the content is preferably 200 parts by mass or less, and more preferably 150 parts by mass or less. When the content of the reinforcing fibers is equal to or more than the lower limit value, the strength improving effect by the reinforcing fibers is excellent. On the other hand, when the content of the reinforcing fibers is equal to or less than the upper limit value, the matrix resin and the hollow particles can be sufficiently contained. Accordingly, the moldability, the weight reduction and dielectric properties and so on can be improved.

The resin composition of the present disclosure may further contain a solvent. A known solvent can be used as the solvent, and it is appropriately selected depending on the type of the matrix resin.

When the resin composition of the present disclosure contains the solvent, the solid content concentration of the resin composition of the present disclosure is preferably from 10% by mass to 90% by mass.

As needed, the resin composition of the present disclosure may further contain additives such as a filler, a coupling agent, a stress reducing agent, a defoaming agent, a leveling agent, a UV absorber, a foaming agent, an antioxidant, a colorant, a thermal stabilizer and a flame retardant, to the extent that does not impair the effects of the present disclosure.

For example, the resin composition of the present disclosure can be obtained by mixing the hollow particles of the present disclosure, the matrix resin, and other components which are added as needed. The method for mixing them is not particularly limited. For example, they can be mixed by use of a known mixing device such as a planetary mixer, a ball mill, a bead mill, a planetary mixer and a roll mill.

When the matrix resin is a thermoplastic resin, the resin composition of the present disclosure may be obtained by melting the matrix resin (the thermoplastic resin), adding the hollow particles of the present disclosure and other components which are added as needed to the melted matrix resin, and melt-kneading them.

Also, the prepreg can be obtained by impregnating the substrate with the resin varnish, which is obtained by mixing the hollow particles of the present disclosure, the matrix resin, and other components added as needed, and drying the resin varnish. As the substrate, examples include, but are not limited to, inorganic fibers such as carbon fibers, glass fibers, metal fibers and ceramic fibers, and organic synthetic fibers such as polyamide fibers, polyester-based fibers, polyolefin-based fibers and novoloid fibers. Of them, glass fibers (glass cloth) are preferred. The form of the substrate is not limited and may be a woven fabric, a non-woven fabric or the like.

### 5. Resin molded body

The resin molded body of the present disclosure is a resin molded body obtained from the resin composition of the present disclosure described above.

The method for obtaining the resin molded body from the resin composition of the present disclosure is appropriately selected from known methods, depending on the type of the matrix resin contained in the resin composition, the form of the resin composition, etc. The method is not particularly limited. When the resin composition of the present disclosure contains a curable resin as the matrix resin, the resin molded body of the present disclosure contains a cured product of the resin composition.

When the resin composition of the present disclosure is varnish, the resin molded body can be obtained as follows, for example: the resin composition is applied on a support, and the applied resin composition is dried and cured as needed, thereby obtaining the resin molded body. The support may be made of resin or metal, and the surface of the support may be coated with a release agent.

The resin composition can be applied by a known method. As the method, examples include, but are not limited to, dip coating, roll coating, curtain coating, die coating, slit coating and gravure coating.

When the resin composition contains the solvent, the resin composition is preferably dried after the application of the resin composition. The drying temperature is preferably a temperature at which the matrix resin is not cured, and it is generally 20°C or more and 200°C or less, and preferably 30°C or more and 150°C or less. The drying time is generally 30 seconds or more and 1 hour or less, and preferably 1 minute or more and 30 minutes or less.

The curing reaction of the resin composition is not particularly limited, and it is performed by a method based on the type of the matrix resin. When the resin composition contains the matrix resin which is curable by heating, the heating temperature for the curing reaction is not particularly limited, and it is appropriately adjusted depending on the type of the resin. The heating temperature is generally 30°C or more and 400°C or less, preferably 70°C or more and 300°C or less, and more preferably 100°C or more and 200°C or less. The curing time is 5 minutes or more and 5 hours or less, and preferably 30 minutes or more and 3 hours or less. The heating method is not particularly limited. For example, an electric oven may be used.

When the resin composition of the present disclosure is a prepreg, the resin molded body can be obtained by curing the prepreg.

The preferred condition of curing the prepreg is the same as the above-described preferred condition of curing the resin composition.

When the resin composition of the present disclosure is a resin composition such as a pelletized resin composition containing a thermoplastic matrix resin, the resin molded body of the present disclosure can be obtained by melt-kneading the resin composition and then molding the same into a desired form by a known molding method, such as extrusion molding, injection molding, press molding and compression molding. The temperature of the melt-kneading is not particularly limited, as long as it is a temperature at which the thermoplastic resin used can be melted. The melt-kneading can be carried out by a known method, and it is not particularly limited. For example, it can be carried out by use of a kneader such as a uniaxial or biaxial kneader.

The form of the resin molded body of the present disclosure is not particularly limited and may be any kind of moldable form. The resin molded body can be in any form such as a sheet form, a film form, a plate form, a tube form, and various kinds of other three-dimensional forms.

As the applications of the resin composition and resin molded body of the present disclosure, examples include, but are not limited to, those in which the resin composition or the resin molded body can be used, among the above-mentioned applications of the hollow particles of the present disclosure.

Of the above-described applications, an embodiment of the resin composition of the present disclosure for use as a semiconductor encapsulant (hereinafter, it will be referred to as "encapsulating resin composition") will be described in detail.

### 6. Encapsulating resin composition

The encapsulating resin composition of the present disclosure is the resin composition of the present disclosure which is used as an encapsulant for semiconductor devices and so on.

The encapsulating resin composition of the present disclosure is characterized in that it contains an epoxy resin as the matrix resin. That is, the encapsulating resin composition of the present disclosure is characterized in that it contains the hollow particles of the present disclosure and an epoxy resin.

By using an epoxy resin as the matrix resin, the encapsulating resin composition can be a resin composition having satisfied moisture resistance, heat resistance and so on which are required of encapsulants.

Since the encapsulating resin composition of the present disclosure further contain the above-described hollow particles of the present disclosure, the encapsulating resin composition is excellent in performance stability in high-humidity environment, while having improved dielectric property.

### [Epoxy resin]

As the epoxy resin contained in the encapsulating resin composition of the present disclosure, a compound containing one or more epoxy groups per molecule, can be used. From the viewpoint of workability in the production and curing of the encapsulating resin composition of the present disclosure, the epoxy resin is preferably a resin that is liquid at ordinary temperature (25°C).

The encapsulating resin composition of the present disclosure preferably contains at least an alicyclic epoxy resin as the epoxy resin. Accordingly, the performance of the resin composition, such as moisture resistance, dielectric property and heat resistance, can be improved.

Alicyclic epoxy resin is a compound containing one or more alicyclic rings (aliphatic hydrocarbon rings) and one or more epoxy groups per molecule. As the alicyclic epoxy compound, (i) a compound containing at least one alicyclic epoxy group per molecule is preferred from the viewpoint of having the above-described excellent performance. The compound is more preferably a compound containing two or more alicyclic epoxy groups per molecule.

The alicyclic epoxy group of (i) the compound containing at least one alicyclic epoxy group per molecule, is an epoxy group comprising adjacent two carbon atoms constituting an alicyclic ring and an oxygen atom. The alicyclic epoxy group is not particularly limited. From the viewpoint of curability, the alicyclic epoxy group is preferably a cyclohexene oxide group, that is, an epoxy group comprising adjacent two carbon atoms constituting a cyclohexane ring and an oxygen atom.

From the viewpoint of the heat resistance of the cured product, (i) the compound containing at least one alicyclic epoxy group per molecule is preferably a compound containing two or more cyclohexene oxide groups per molecule, and more preferably a compound represented by the following formula (A). In the formula (A), a substituent (e.g., an alkyl group containing 1 to 6 carbon atoms) may be bound to one or more carbon atoms constituting the alicyclic epoxy group.

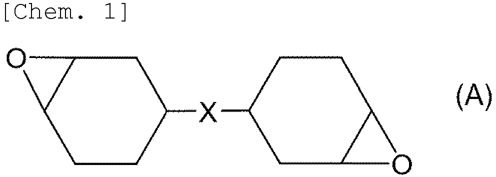

In the formula (A), X represents a single bond or a linking group, and X is preferably a linking group. The linking group is a divalent group containing one or more atoms.

As the linking group, examples include, but are not limited to, a divalent hydrocarbon group, a carbonyl group, an ether bond, an ester bond, a carbonate group, an amide bond, and a group formed by linking two or more of them. The linking group is preferably a linking group containing an oxygen atom, and more preferably a linking group containing an ester bond. The linking group is particularly preferably a group in which at least one ester bond is linked to a linear alkylene group containing 1 to 18 carbon atoms, and more particularly preferably a group in which one ester bond is bound to a linear alkylene group containing 1 to 6 carbon atoms.

The compound represented by the formula (A) is not particularly limited. As the compound, examples include, but are not limited to, (3,3',4,4'-diepoxy)bicyclohexyl, 3,4-epoxycyclohexylmethyl-3',4'-epoxycyclohexane carboxylate, ε-caprolactone-modified 3,4-epoxycyclohexylmethyl-3',4'-epoxycyclohexane carboxylate, 2,2-bis(3,4-epoxycyclohexane-1-yl)propane, bis(3,4-epoxycyclohexylmethyl)ether, 1,2-bis(3,4-epoxycyclohexane-1-yl)ethane, and 1,2-epoxy-1,2-bis(3,4-epoxycyclohexane-1-yl)ethane. Of them, 3,4-epoxycyclohexylmethyl-3',4'-epoxycyclohexane carboxylate is preferably used.

As the compound represented by the formula (A), for example, a commercially-available product such as "CELLOXIDE 2021P" (product name, manufactured by Daicel Corporation, compound name: 3,4-epoxycyclohexylmethyl-3',4'-epoxycyclohexane carboxylate), "CELLOXIDE 2081" (product name, manufactured by Daicel Corporation, compound name: caprolactone-modified 3,4-epoxycyclohexylmethyl-3',4'-epoxycyclohexane carboxylate), "CELLOXIDE 8000" (product name, manufactured by Daicel Corporation, compound name: (3,3',4,4'-diepoxy)bicyclohexyl) and "EPOLEAD GT401" (product name, manufactured by Daicel Corporation) can be used.

Of the compounds exemplified above as (i) the compound containing at least one alicyclic epoxy group per molecule, as the compound containing two or more alicyclic epoxy groups per molecule, examples include, but are not limited to, the compound represented by the formula (A) and a compound containing a cyclohexene oxide group and a cyclopentene oxide group per molecule. As such a compound, examples include, but are not limited to, products manufactured by ENEOS Corporation such as EPOCHALIC (registered trademark) THI-DE, DE-102 and DE-103.

Of the compounds exemplified above as (i) the compound containing at least one alicyclic epoxy group per molecule, as the compound containing one alicyclic epoxy group per molecule, examples include, but are not limited to, products manufactured by Daicel Corporation such as "CYCLOMER M100" and "CELLOXIDE 2000".

As the alicyclic epoxy compound, (ii) a compound containing an epoxy group that is directly bound to an alicyclic ring by a single bond, can be also used. The compound is not particularly limited. As the compound, examples include, but are not limited to, an adduct of 2,2-bis(hydroxymethyl)-1-butanol with 1,2-epoxy-4-(2-oxiranyl)cyclohexane, such as "EHPE 3150" (product name, manufactured by Daicel Corporation).

As the alicyclic epoxy compound, (iii) a compound containing an alicyclic ring and a glycidyl group can be also used. The compound is not particularly limited. As the compound, examples include, but are not limited to, 2,2-bis[4-(2,3-epoxypropoxy)cyclohexyl]propane, 2,2-bis[3,5-dimethyl-4-(2,3-epoxypropoxy)cyclohexyl]propane, hydrogenated bisphenol A-type epoxy resin, bis[2-(2,3-epoxypropoxy)cyclohexyl]methane, [2-(2,3-epoxypropoxy)cyclohexyl][4-(2,3-epoxypropoxy)cyclohexyl]methane, bis[4-(2,3-epoxypropoxy)cyclohexyl]methane, bis[3,5-dimethyl-4-(2,3-epoxypropoxy)cyclohexyl]methane, hydrogenated bisphenol F-type epoxy resin, hydrogenated biphenol-type epoxy resin, hydrogenated novolac-type epoxy resin, and hydrogenated naphthalene-type epoxy resin.

These alicyclic epoxy resins can be used alone or in combination of two or more.

In the encapsulating resin composition of the present disclosure, the epoxy resin may contain an epoxy resin free of an alicyclic structure. By appropriately selecting and using the epoxy resin free of an alicyclic structure, desired properties can be imparted to the encapsulating resin composition of the present disclosure. For example, by selecting and using a highly-flexible resin as the epoxy resin free of an alicyclic structure, stress relaxation property can be imparted to the encapsulating resin composition of the present disclosure.

The epoxy resin free of an alicyclic structure is not particularly limited. As the epoxy resin free of an alicyclic structure, examples include, but are not limited to, bixylenol-type epoxy resin, bisphenol A-type epoxy resin, bisphenol F-type epoxy resin, bisphenol S-type epoxy resin, bisphenol AF-type epoxy resin, trisphenol-type epoxy resin, naphthol novolac-type epoxy resin, phenol novolac-type epoxy resin, tert-butyl-catechol-type epoxy resin, naphthalene-type epoxy resin, naphthol-type epoxy resin, anthracene-type epoxy resin, glycidyl amine-type epoxy resin, glycidyl ester-type epoxy resin, cresol novolac-type epoxy resin, biphenyl-type epoxy resin, biphenyl aralkyl-type epoxy resin, linear aliphatic epoxy resin, epoxy resin having butadiene structure, heterocyclic epoxy resin, spiro ring-containing epoxy resin, naphthylene ether-type epoxy resin, trimethylol-type epoxy resin and tetraphenylethane-type epoxy resin. Of them, bisphenol A-type epoxy resin is preferred from the viewpoint of improving conformability to surface irregularities at the time of encapsulation of semiconductor devices and so on, that is, from the viewpoint of improving the capability to fill in surface irregularities. On the other hand, biphenyl aralkyl-type epoxy resin is preferred from the viewpoint of heat resistance.

From the viewpoint of reactivity, the epoxy resin free of an alicyclic structure preferably contains two or more epoxy groups per molecule.

The above-described epoxy resins free of an alicyclic structure can be used alone or in combination of two or more.

In the encapsulating resin composition of the present disclosure, from the viewpoint of improving performances such as moisture resistance, dielectric property and heat resistance, the content of the alicyclic epoxy resin is preferably 10 parts by mass or more, more preferably 30 parts by mass or more, and still more preferably 50 parts by mass or more in 100 parts by mass of the epoxy resin.

In the encapsulating resin composition of the present disclosure, from the viewpoint of improving performances such as moisture resistance, dielectric property and heat resistance, the content of 3,4-epoxycyclohexylmethyl-3',4'-epoxycyclohexane carboxylate is preferably 30 parts by mass or more, more preferably 40 parts by mass or more, and still more preferably 50 parts by mass or more in 100 parts by mass of the epoxy resin.

In the encapsulating resin composition of the present disclosure, the content of the epoxy resin is not particularly limited. However, from the viewpoint of capability to fill in surface irregularities, with respect to 100 parts by mass of the total solid content of the encapsulating resin composition, the epoxy resin content is preferably 20 parts by mass or more, more preferably 30 parts by mass or more, and still more preferably 40 parts by mass or more. On the other hand, from the viewpoint of suppressing a deterioration in dielectric property, the content of the epoxy resin is preferably 95 parts by mass or less, more preferably 90 parts by mass or less, and still more preferably 80 parts by mass or less.

### [Hollow particles]

The hollow particles contained in the encapsulating resin composition of the present disclosure are the above-described hollow particles of the present disclosure.

In the encapsulating resin composition of the present disclosure, the content of the hollow particles is not particularly limited. From the viewpoint of suppressing a reduction in performance stability while improving the dielectric property of the resin composition, the content of the hollow particles is preferably from 1 part by mass to 70 parts by mass, with respect to 100 parts by mass of the total solid content of the resin composition. From the viewpoint of improving the dielectric property of the resin composition, the lower limit of the content of the hollow particles more preferably 3 parts by mass or more, and still more preferably 5 parts by mass or more. From the viewpoint of suppressing a reduction in the performance stability of the resin composition and suppressing a reduction in the capability to fill in surface irregularities, the upper limit of the content of the hollow particles is more preferably 50 parts by mass or less, and still more preferably 40 parts by mass or less.

### [Curing accelerator]

The encapsulating resin composition of the present disclosure generally contains a curing accelerator. As the curing accelerator, a compound that is generally used as an epoxy resin curing accelerator can be appropriately selected, without any particular limitation. As the curing accelerator, examples include, but are not limited to, a phosphorus-based curing accelerator, an amine-based curing accelerator, an imidazole-based curing accelerator, a guanidine-based curing accelerator and a metal-based curing accelerator.

These curing accelerators can be used alone or in combination of two or more.

In the present disclosure, the curing accelerator is not particularly limited. From the point of view that the resin composition with excellent heat resistance is easily obtained, an imidazole-based curing accelerator is preferably used as the curing accelerator. As the imidazole-based curing accelerator, examples include, but are not limited to, an imidazole compound such as 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, 2,4-diamino-6-[2'-methylimidazolyl-(1')]-ethyl-s-triazine isocyanuric acid adduct, 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrrolo[1,2-a]benzimidazole, 1-dodecyl-2-methyl-3-benzylimidazolium chloride, 2-methylimidazoline and 2-phenylimidazoline, and an adduct of an imidazole compound and epoxy resin. Of them, at least one selected from the group consisting of 2-ethyl-4-methylimidazole, 1-benzyl-2-methylimidazole, 1-benzyl-2-phenylimidazole and 2-heptadecylimidazole is preferred.

In the encapsulating resin composition of the present disclosure, the content of the curing accelerator is appropriately adjusted depending on the type of the curing accelerator, and is it not particularly limited. With respect to 100 parts by mass of the epoxy resin, the content of the curing accelerator is preferably from 0.1 parts by mass to 7 parts by mass, and more preferably from 0.5 parts by mass to 5 parts by mass. When the content of the curing accelerator is equal to or more than the lower limit value, an excellent curing acceleration effect is obtained.

### [Curing agent]

The encapsulating resin composition of the present disclosure preferably contains a curing agent. As the curing agent, a compound that is generally used as an epoxy resin curing agent can be appropriately selected, and it is not particularly limited. As the curing agent, examples include, but are not limited to, an amine-based curing agent, an acid anhydride-based curing agent, an imidazole-based curing agent, a thiol-based curing agent, a phenol-based curing agent, a naphthol-based curing agent, a benzoxazine-based curing agent, a cyanate ester-based curing agent and a carbodiimide-based curing agent. These curing agents can be used alone or in combination of two or more.

From the point of view that the encapsulating resin composition of the present disclosure obtains excellent storage stability, an acid anhydride-based curing agent is preferably used as the curing agent. The acid anhydride-based curing agent is not particularly limited. As the acid anhydride-based curing agent, examples include, but are not limited to, hexahydrophthalic anhydride, methylhexahydrophthalic anhydride, 1,2,3,6-tetrahydrophthalic anhydride, methyltetrahydrophthalic anhydride, methylendomethylene tetrahydrophthalic anhydride, cyclohexane-1,2,4-tricarboxylic acid-1,2-anhydride, dodecenyl succinic anhydride, succinic anhydride, hydrogenated pyromellitic anhydride, hydrogenated biphenyl dianhydride, phthalic anhydride, tetrahydrophthalic anhydride and methylcyclohexene dicarboxylic acid anhydride. Of them, from the viewpoint of improving the storage stability of the encapsulating resin composition, at least one selected from the group consisting of methylhexahydrophthalic anhydride and methyltetrahydrophthalic anhydride is preferred.

In the encapsulating resin composition of the present disclosure, the content of the curing agent is appropriately adjusted depending on the type of the curing agent, and it is not particularly limited. With respect to one equivalent of the epoxy group of the epoxy resin, the curing agent is preferably from 0.5 equivalents to 1.5 equivalents, and more preferably from 0.8 equivalents to 1.2 equivalents. In the acid anhydride-based curing agent, one acid anhydride group is calculated as one equivalent.

Also in the encapsulating resin composition of the present disclosure, with respect to 100 parts by mass of the epoxy resin, the content of the curing agent is preferably from 50 parts by mass to 200 parts by mass, and more preferably from 70 parts by mass to 120 parts by mass.

### [Other additives]

The encapsulating resin composition of the present disclosure may further contain other additives that are generally used in semiconductor encapsulants, such as a release agent, a plasticizer, a filler, an antioxidant, a light stabilizer, a defoaming agent, a leveling agent, a coupling agent, a surfactant, a flame retardant, a colorant and an ion adsorbent.

The release agent is not particularly limited. As the release agent, examples include, but are not limited to, a long-chain carboxylic acid (such as stearic acid, behenic acid and montanic acid) and a metal salt thereof; a higher alcohol such as stearyl alcohol; an amide such as stearyl bisamide; an ester such as carnauba wax and phosphoric acid ester; paraffin; silicone oil such as dimethyl silicone oil and methylphenyl silicone oil. They can be used alone or in combination of two or more.

The content of the release agent is not particularly limited. With respect to 100 parts by mass of the epoxy resin, the content of the release agent can be 1 part by mass to 8 parts by mass, for example. By incorporating the release agent in the encapsulating resin composition of the present disclosure, the slidability of the cured product can be improved.

The plasticizer is not particularly limited. As the plasticizer, examples include, but are not limited to, polyhydric alcohol. As the polyhydric alcohol, examples include, but are not limited to, glycerin, sorbitol, polyglycerol, pentaerythritol and trimethylolpropane.

The content of the plasticizer is not particularly limited. With respect to 100 parts by mass of the epoxy resin, the content of the plasticizer can be 5 parts by mass to 30 parts by mass.

The filler may be organic or inorganic filler. As the filler, an inorganic filler is preferably used. The inorganic filler is not particularly limited. As the inorganic filler, examples include, but are not limited to, barium sulfate, barium titanate, silica (e.g., amorphous silica, crystalline silica, fused silica, spherical silica), talc, clay, magnesium carbonate, calcium carbonate aluminum oxide, aluminum hydroxide, silicon nitride and aluminum nitride. Of them, silica is preferably used from the point of view that it has excellent dispersibility and a relatively small thermal expansion coefficient, and desired cured film properties can be easily obtained.

The filler may be surface-modified. The surface modifying method is not particularly limited. It is preferably a surface modifying method using a silane coupling agent, due to the following reasons: it is a simple and easy method; a variety of functional groups are applicable; and desired properties can be easily imparted.

The content of the filler is not particularly limited. On the basis of the total solid content of the encapsulating resin composition, the content of the filler can be 30% by volume or more and 85% by volume or less, for example.

### [Method for producing the encapsulating resin composition]

The encapsulating resin composition of the present disclosure can be obtained by, for example, mixing the above-described epoxy resin, hollow particles, curing accelerator and, as needed, curing agent and other additives by a known method. As the mixing method, examples include, but are not limited to, a method using a known mixing or kneading device such as a planetary mixer, a ball mill, a bead mill, a roll mill, an extruder and a kneader. As needed, the encapsulating resin composition of the present disclosure may further contain a solvent.

Also, the encapsulating resin composition of the present disclosure may be in a B-stage state.

### [Cured product]

The cured product of the encapsulating resin composition of the present disclosure can be obtained by, for example, heating the above-described encapsulating resin composition of the present disclosure. The details of the heating temperature, curing time and heating method for curing the encapsulating resin composition of the present disclosure are the same as those provided above in the description of the resin composition of the present disclosure.

### 7. Semiconductor device

The semiconductor device of the present disclosure is characterized in that it contains, as an encapsulant, the cured product of the encapsulating resin composition of the present disclosure described above.

In general, the semiconductor device of the present disclosure has such a structure, that a semiconductor chip is disposed on a substrate and encapsulated by an encapsulant.

The method for encapsulating the semiconductor chip disposed on the substate by use of the encapsulating resin composition of the present disclosure, is not particularly limited. For example, various kinds of molding methods such as transfer molding and cast molding can be employed.

### Examples

Hereinbelow, the present disclosure is described more specifically using examples and comparative examples. However, the present disclosure is not limited to these examples. Also, "part (s) " and "%" are on a mass basis unless otherwise specified.

### [Example 1]

### (1) Mixture liquid preparation step

First, the following materials were mixed to produce an oil phase.
Divinylbenzene: 37.5 parts
Ethylvinylbenzene: 1.6 parts
t-Butylperoxy diethylacetate: 0.89 parts
Hydrophobic solvent: Heptane 60.8 parts

Next, in a stirring tank, an aqueous solution in which 11.0 parts of sodium hydroxide (an alkali metal hydroxide) was dissolved in 55 parts of deionized water, was gradually added under stirring to an aqueous solution in which 15.7 parts of magnesium chloride (a water-soluble polyvalent metal salt) was dissolved in 225 parts of deionized water, thereby preparing a magnesium hydroxide (sparingly water-soluble metal hydroxide) colloidal dispersion (magnesium hydroxide: 8 parts). The dispersion was used as an aqueous phase.

The obtained aqueous phase and oil phase were mixed, thereby preparing a mixture liquid.

### (2) Suspension step

The mixture liquid obtained in the mixture liquid preparation step was suspended with an emulsifying disperser (product name: HOMOMIXER, manufactured by: PRIMIX Corporation) at a rotational frequency of 4,000 rpm for one minute, thereby preparing a suspension in which droplets of a monomer composition including the hydrophobic solvent were dispersed in water.

### (3) Polymerization step

In a nitrogen atmosphere, the temperature of the suspension obtained in the suspension step was increased to 80°C. The suspension was stirred for 24 hours under a temperature condition of 80°C, thereby performing a polymerization reaction. Accordingly, a precursor composition was obtained, which was a slurry solution in which precursor particles including the hydrophobic solvent were dispersed in water.

### (4) Washing step

The precursor composition obtained in the polymerization step was treated with dilute sulfuric acid (25°C, 10 minutes) to bring the pH of the composition to 5.5 or less. Next, by adding a non-ionic surfactant, affinity at the interfaces between water and the precursor particles were improved, thereby loosening the aggregation of the precursor particles and obtaining a pH adjusted slurry. Then, while kept at room temperature (25°C), the precursor particles were separated from the pH adjusted slurry by filtration, and the separated precursor particles were dehydrated. Then, 200 parts of deionized water was added to the dehydrated precursor particles to reslurry the resultant. In the same manner as above, after the aggregation of the precursor particles was loosened, filtration and dehydration were performed. A series of these steps (the step of reslurrying the precursor particles, the step of loosening the aggregation of the precursor particles, the step of filtering the precursor particles and the step of dehydrating the precursor particles) was repeatedly performed three times (i.e. the number of washing times: 3 times), thereby obtaining the precursor particles including the hydrophobic solvent.

### (5) Solvent removal step

The precursor particles obtained by the washing step were dried with a drier at a temperature of 40°C for preliminary drying.

Next, the precursor particles were subjected to heating treatment for 12 hours with a vacuum dryer in a vacuum condition at 200°C, thereby removing the included hydrophobic solvent from the particles. Accordingly, the hollow particles of Example 1 were obtained.

### [Example 2]

The hollow particles of Example 2 were produced in the same manner as Example 1, except that in "(4) Washing step", the number of washing times was changed from 3 to 4.

### [Examples 3 to 5]

The hollow particles of Examples 3 to 5 were produced in the same manner as Example 1, except that in "(1) Mixture liquid preparation step", the type and amount of the polymerizable monomer added to the oil phase was changed according to Table 1, and in "(4) Washing step", the number of washing times was changed from 3 to 4.

### [Comparative Example 1]

The hollow particles of Comparative Example 1 were produced in the same manner as Example 1, except that in only the following tasks were performed in "(4) Washing step": the precursor composition obtained by the polymerization step was treated with dilute sulfuric acid (25°C, 10 minutes) to obtain a pH of 5.5 or less, and the precursor particles were separated by filtration and dehydrated.

### [Comparative Example 2]

The hollow particles of Comparative Example 2 were produced in the same manner as Example 1, except that in " (4) Washing step", the number of washing times was changed from 3 to 1.

### [Comparative Example 3]

The hollow particles of Comparative Example 3 were produced in the same manner as Example 1, except that in " (4) Washing step", the number of washing times was changed from 3 to 2.

### [Comparative Example 4]

The hollow particles of Comparative Example 4 were produced in the same manner as Example 1, except that in "(1) Mixture liquid preparation step", 0.313 parts of an anionic surfactant was added to the magnesium chloride aqueous solution when preparing the aqueous phase, and in "(4) Washing step", the number of washing times was changed from 3 to 2.

### [Comparative Example 5]

The hollow particles of Comparative Example 5 were produced in the same manner as Production Example 1 described in Patent Document 1 (JP-A No. 2000-313818).

In particular, 70 parts of styrene, 27 parts of butadiene, 3 parts of itaconic acid and 12 parts of t-dodecyl mercaptan were added to an aqueous solution obtained by dissolving 0.5 parts of reactive emulsifier SE10N (product name, manufactured by ADEKA Corporation) and 1.0 part of ammonium persulfate in 200 parts of distilled water. While stirring the aqueous solution, the aqueous solution was subjected to a polymerization reaction at 75°C for 8 hours, thereby obtaining polymer particles. Next, using the polymer particles as a seed polymer, the following polymerization was carried out. That is, 10 parts of the polymer particles, 0.5 parts of ammonium persulfate and, as surfactants, 0.1 parts of polyoxyethylene nonylphenyl ether and 0.4 parts of ammonium lauryl sulfate, were dispersed in 900 parts of distilled water. Next, a mixture of 50 parts of methyl methacrylate, 40 parts of divinylbenzene, 10 parts of α-methylstyrene and 20 parts of toluene was added thereto, and the thus-obtained mixed solution was subjected to a polymerization reaction at 75°C for 5 hours. As a result, a dispersion of precursor particles was obtained, which contained toluene in their interior. The obtained precursor particles were spray-dried, thereby obtaining the hollow particles of Comparative Example 5.

### [Comparative Example 6]

The hollow particles of Comparative Example 6 were produced as the hollow particles corresponding to Patent Document 3 (International Publication No. WO2021/085189).

First, the following materials were mixed to produce an oil phase.
Styrene: 12.5 parts
Divinylbenzene: 16.2 parts
Ethylvinylbenzene: 3.8 parts
HS CRYSTA 4100 (product name, side-chain crystalline polyolefin manufactured by Hokoku Corporation): 3.3 parts
BLEMMER (registered trademark) 50 PEP-300 (product name, polyethylene glycol-propylene glycol monomethacrylate manufactured by NOF Corporation): 3.3 parts
PEROYL L (product name, polymerization initiator manufactured by NOF Corporation): 1.07 parts
Hydrophobic solvent: Heptane 26.04 parts

Next, an aqueous phase was produced by mixing 370 parts of deionized water and 0.18 parts of RAPISOL A-80 (surfactant manufactured by NOF Corporation).

The oil phase was added to the aqueous phase, and a suspension was prepared by use of an ultrasonic homogenizer. The suspension thus obtained was heated at 70°C for 4 hours for polymerization, thereby obtaining a slurry. The obtained slurry was heated at 100°C for 24 hours, thereby producing the hollow particles of Comparative Example 6.

### [Comparative Example 7]

The hollow particles of Comparative Example 7 were produced in the same manner as Example 1, except for the following: in "(1) Mixture liquid preparation step", the type and amount of the polymerizable monomer and hydrophobic solvent added to the oil phase were changed according to Table 1; in "(3) Polymerization step", the polymerization temperature was changed to 40°C, and the polymerization time was changed to 4 hours: and in "(4) Washing step", neither the addition of the non-ionic surfactant to the pH adjusted slurry nor the addition of the non-ionic surfactant to the reslurried slurry in order to loosen the aggregation of the precursor particles, were not performed.

### [Evaluation]

The hollow particles obtained in the above-described examples and the comparative examples were measured and evaluated as follows. The results are shown in Table 1.

### 1. Volume average particle diameter (Dv)

The volume average particle diameter (Dv) of the hollow particles was measured with a particle size distribution measuring device by the Coulter counter method (product name: MULTISIZER 4e, manufactured by: Beckman Coulter, Inc.) The measurement condition was as follows.
Aperture diameter: 50 µm
Dispersion medium: ISOTON II (product name)
Concentration: 10%
Number of the measured hollow particles: 100,000 particles

More specifically, 0.2 g of the sample hollow particles were put in a beaker. As a dispersant, a surfactant aqueous solution (product name: DRIWEL, manufactured by: Fujifilm Corporation) was added thereto. In addition, 2 mL of the dispersion medium was added to wet the hollow particles. Then, 10 mL of the dispersion medium was added thereto. The mixture was dispersed for one minute with an ultrasonic disperser. Then, the measurement with the above-described particle size measuring device was carried out.

### 2. Void ratio

### 2-1. Measurement of apparent density of hollow particles

First, approximately 30 cm³ of the hollow particles were introduced into a measuring flask with a volume of 100 cm³, and the mass of the introduced hollow particles was precisely weighed. Next, the measuring flask in which the hollow particles were introduced, was precisely filled with isopropanol up to the marked line while care was taken so that air bubbles did not get in. The mass of the isopropanol added to the measuring flask was precisely weighed, and the apparent density D₁ (g/cm³) of the hollow particles was calculated by the following formula (I). Apparent density D1 = [Mass of the hollow particles]/(100-[Mass of the isopropanol]/[Specific gravity of the isopropanol at the measuring temperature])

### 2-2. Measurement of true density of hollow particles

The hollow particles were pulverized in advance; approximately 10 g of the pulverized hollow particles were introduced into a measuring flask with a volume of 100 cm³; and the mass of the introduced pulverized particles was precisely weighed.

Then, similarly to the measurement of the apparent density mentioned above, isopropanol was added to the measuring flask; the mass of the isopropanol was precisely weighed; and the true density D₀ (g/cm³) of the hollow particles was calculated by the following formula (II). True density D0 = [Mass of the pulverized hollow particles]/(100-[Mass of the isopropanol]/[Specific gravity of the isopropanol at the measuring temperature])

### 2-3. Calculation of void ratio

The void ratio of the hollow particles was calculated by the following formula (III) where D₁ is the apparent density of the hollow particles and D₀ is the true density thereof. Void ratio (%) = 100-(Apparent density D1/True density D0)×100

### 3. Residual monomer content

In all of Examples and Comparative Examples, for the measurement of the residual monomer content, the hollow particles after the washing step (the precursor particles including the hydrophobic solvent) were prepared as a measurement sample. The residual monomer content of each of the measurement samples was measured by the following method.

First, 3 g of the solid content of the hollow particles was collected and precisely weighed in milligrams. Next, 27 g of ethyl acetate was added thereto, and they were stirred for 15 minutes. Then, 13 g of methanol was added thereto, and they were stirred for 10 minutes. A solution thus obtained was left to stand to deposit an insoluble component, and the supernatant of the solution was collected as a measurement sample. Next, the measured sample was injected into a gas chromatograph, and the content of the unreacted polymerizable monomer in the measurement sample was quantified by gas chromatography (GC) in the following condition. The content of the unreacted polymerizable monomer contained in the solid content of the hollow particles was calculated and regarded as the residual monomer content.

### (Analysis conditions)

Apparatus: GC-2010 (manufactured by Shimadzu Corporation)
Column: DB-5 (manufactured by Agilent Technologies Japan, Ltd.)
Membrane thickness 0.25 µm, Inner diameter 0.25 mm, Length 30 m
Detector: FID
Carrier gas: Nitrogen (linear velocity: 28.8 cm/sec)
Temperature of the injection port: 200°C
Temperature of the detector: 250°C
Temperature of the oven: Raised from 40°C to 230°C at a rate of 10°C/minute, and held at 230°C for 2 minutes
Amount of sampling: 2 µL

### 4. pH and conductivity of aqueous dispersion of hollow particles

A non-ionic surfactant (product name: SN DEFOAMER 180, manufactured by: San Nopco Limited, a polyether-based surfactant) was dissolved at a concentration of 0.1% by mass in deionized water to obtain an aqueous solution (conductivity: 1 µS/cm or less). To 100 mL of the aqueous solution, hollow particles with a volume of 0.35 cm³ were added. At room temperature (25°C), the aqueous solution was stirred for three hours at 300 rpm, thereby obtaining an aqueous dispersion of the hollow particles. The pH and conductivity of the obtained aqueous dispersion of the hollow particles were measured. By visual confirmation, the obtained aqueous dispersion of the hollow particles was found to be in such a state, that powder was not present in the upper part and was entirely dispersed in the water. As the hollow particles with a volume of 0.35 cm³, hollow particles having the weight (g) obtained by the following formula (1) were measured, collected and used. Weight (g) of the hollow particles with a volume of 0.35 cm3 = Apparent density D1 (g/cm3) of the hollow particles × 0.35 (cm3)

### 5. Content of surfactant on particle surface

First, 50 ml of ultrapure water and 5 g of the hollow particles were accurately weighed and mixed well. The mixture was subjected to ultrasonic irradiation for 30 minutes and then filtered with a 0.45 µm syringe membrane filter. The thus-obtained filtrate was freeze-dried, and the thus-obtained residue was mixed with 1 g of tetramethylsilane (TMS) as a solvent and dissolved. Then, ¹H-NMR measurement was carried out in the following condition. For the surfactant specified from the ¹H-NMR spectrum, a calibration curve was prepared based on TMS intensity basis, and the amount of the surfactant extracted from the surface of the hollow particles was calculated. The calibration curve was prepared from the TMS intensity and the peak intensity ratio derived from the surfactant. The ratio of the amount of the surfactant extracted from the surface of the hollow particles with respect to the mass of the hollow particles, was calculated and regarded as the content of the surfactant present on the surface of the hollow particles.

The particles for which the surfactant was not detected from the ¹H-NMR spectrum, were regarded as "not detected (ND)". <¹H-NMR measurement condition>
Device: FT-NMR device
Resonant frequency: 400 MHz
Measurement mode: 1H-NMR
Pulse width: 5.0 µs (Pulse angle: 90°)
Measurement range: 26 ppm (Frequency range: 10500 Hz)
Accumulated number of times: 1024
Measurement temperature: 40°C
Solvent: Deuterated chloroform (TMS (tetramethylsilane) 1%)
Reference material: Tetramethylsilane-derived peak: 0.00 ppm (Internal standard method)

### 6. Content of metal in particles

Wet digestion of the weighed hollow particles (10 g) was carried out by use of a microwave (MULTIWAVE 3000 manufactured by PerkinElmer Inc.) ICP optical emission spectroscopy of the thus-obtained degradation product was carried out by use of an ICP optical emission spectrometer (OPTIMA 2100 DV manufactured by PerkinElmer Inc.) to measure the total mass of the metal. The metal species was specified by elemental analysis by X-ray fluorescence spectrometry (XRF). The ratio of the total mass of the metal in the degradation product with respect to the mass of the hollow particles, was calculated and regarded as the metal content in the hollow particles.

### 7. Relative permittivity (Dk) and dielectric dissipation factor (Df)

Using a perturbation-type measuring device (manufactured by: AET Inc., model: ADMS01Nc), the relative permittivity and dielectric dissipation factor of the hollow particles were measured at a frequency of 10 GHz and at room temperature (25°C).

### 8. Residual void ratio in molded body

First, 10 parts of the hollow particles and 90 parts of polypropylene (manufactured by: Japan Polypropylene Corporation, product name: NOVATEC-PP MA1B) were mixed by a blender. Next, the obtained mixture was poured into a mold, heated at 230°C to dissolve the polypropylene, removed from the mold, cooled down to 130°C, and then pressed at 15 MPa (surface pressure) by a press machine, thereby producing a molded body. Then, the residual void ratio (%) of the hollow particles was calculated from the specific gravity of the molded body and that of the hollow particles. As the residual void ratio increases, the hollow particles can be evaluated as being better in pressure resistance.

### 9. Reliability test in high-humidity environment

### 9-1. Preparation of resin varnish containing hollow particles

First, 90 parts of brominated epoxy resin (product name: YDB-500EK75, manufactured by: Tohto Kasei Co., Ltd., epoxy equivalent: 500, solid content: 75% by mass) and 10 parts of cresol novolac-type epoxy resin (product name: YDCN220EK75, manufactured by: Tohto Kasei Co., Ltd., epoxy equivalent: 210, solid content: 75% by mass) were dissolved in a mixed solvent (room temperature) of 20 parts of dimethylformamide (DMF) and 6 parts of methyl ethyl ketone (MEK). In addition, 2 parts of dicyandiamide (DICY) (manufactured by Nippon Carbide Industries, Co., Inc.) and 0.1 parts of 2-ethyl-4-methylimidazole (product name: CUREZOL (registered trademark) 2E4MZ, manufactured by: Shikoku Chemicals Corporation) were added thereto, and they were mixed by stirring, thereby preparing a resin varnish.

Next, the resin varnish was cooled to room temperature, and 95 parts of the cooled resin varnish and 5 parts of the hollow particles were mixed by stirring with a dispersion mixer at 3000 rpm for 30 minutes, thereby obtaining the resin varnish containing the hollow particles.

### 9-2. Production of prepreg

A glass cloth (product name: WEA116E, manufactured by: Nitto Boseki Co., Ltd.) was impregnated with the obtained resin varnish containing the hollow particles. Then, the cloth was dried by heating at a temperature of from 150°C to 170°C for 3 minutes to 10 minutes, thereby obtaining a prepreg.

### 9-3. Production of double-sided copper clad laminate

A copper foil having a thickness of 35 µm was disposed on both sides of the obtained prepreg. They were heated and pressed in the following curing condition, thereby obtaining a double-sided copper clad laminate having a thickness of 0.13 mm.
Temperature: 180°C
Heating and pressing time: 2 hours
Pressure: 2.94 MPa (30 kg/cm²)

### 9-4. Reliability test

Pressure cooker treatment (110°C, humidity 85% RH, 100 hours) of the thus-obtained, double-sided copper clad laminate was performed. After the treatment, a voltage of 50 V was applied to the double-sided copper clad laminate for a predetermined time; the resistance of the laminate was measured; and the presence or absence of an abnormality was checked and evaluated in accordance with the following evaluation criterion. In the case where a change occurred in the resistance, it was regarded as "abnormal". The change in the resistance is considered to be due to the corrosion of the copper substrate of the laminate.

### (Reliability test evaluation criteria)

A: No abnormality occurred even after the voltage was applied for 400 hours.
B: No abnormality occurred even after the voltage was applied for 300 hours; however, an abnormality occurred before the voltage applying time reached 400 hours.
C: No abnormality occurred even after the voltage was applied for 200 hours; however, an abnormality occurred before the voltage applying time reached 300 hours.
D: No abnormality occurred even after the voltage was applied for 100 hours; however, an abnormality occurred before the voltage applying time reached 200 hours.
E: An abnormality occurred before the voltage applying time reached 100 hours.

### [Table 1]

**Table 1**

| | | Example 1 | Example 2 | Example 3 | Example 4 | Example 5 |
|---|---|---|---|---|---|---|
| Crosslinkable monomer | DVB (parts) | 37.5 | | 28.5 | 31.7 | 22.3 |
| Non-crosslinkable monomer | EVB (parts) | 1.6 | | 1.2 | 7.4 | 13.1 |
| | St (parts) | | | 9.4 | | |
| | MMA (parts) | | | | | |
| | α-MSt (parts) | | | | | |
| | 50PEP-300 (parts) | | | | | |
| Crosslinkable monomer (%) | | 96 | | 73 | 81 | 63 |
| Non-crosslinkable monomer (%) | | 4 | | 27 | 19 | 37 |
| Hydrophobic solvent | Heptane (parts) | 60.8 | | 60.8 | 60.8 | 60.8 |
| | Hexane (parts) | | | | | |
| | Toluene (parts) | | | | | |
| Dispersion stabilizer | Anionic surfactant (parts) | | | | | |
| | Mg(OH)₂ (parts) | 8 | | 8 | 8 | 8 |
| Washing step | Number of washing times (times) | 3 | 4 | 4 | 4 | 4 |
| | Particle aggregation state after pH adjustment | No aggregation found | | No aggregation found | No aggregation found | No aggregation found |
| | Dv (µm) | 2.28 | | 2.17 | 2.11 | 2.37 |
| | Void ratio (%) | 70 | | 70 | 70 | 70 |
| | Residual monomer content (ppm) | 1000 | | 1100 | 1100 | 1200 |
| | Aqueous dispersion conductivity (µS/cm) | 40 | 11 | 13 | 12 | 11 |
| | Aqueous dispersion pH | 7.1 | 7.1 | 6.9 | 7.0 | 7.2 |
| Hollow particles | Surfactant content (ppm) | ND | ND | ND | ND | ND |
| | Metal content (ppm) | 650 | 160 | 152 | 166 | 153 |
| | Relative permittivity (@ 10 GHz) | 1.36 | 1.35 | 1.35 | 1.34 | 1.33 |
| | Dielectric dissipation factor (@ 10 GHz) | 8.44E-04 | 8.16E-04 | 3.76E-04 | 3.24E-04 | 2.93E-04 |
| | Pressure resistance test (Residual void ratio (%)) | 100 | 100 | 95 | 94 | 90 |
| | Reliability test | B | A | A | A | A |

**Table 1-continued**

| | | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|
| Crosslinkable monomer | DVB (parts) | 37.5 | | | | 40 | 16.2 | 25.2 |
| Non-crosslinkable monomer | EVB (parts) | 1.6 | | | | | 3.8 | 1.0 |
| | St (parts) | | | | | | 12.5 | |
| | MMA (parts) | | | | | 50 | | |
| | α-MSt (parts) | | | | | 10 | | |
| | 50PEP-300 (parts) | | | | | | 3.3 | |
| Crosslinkable monomer (%) | | 96 | | | | 40 | 45 | 96 |
| Non-crosslinkable monomer (%) | | 4 | | | | 60 | 55 | 4 |
| Hydrophobic solvent | Heptane (parts) | 60.8 | | | | | 26.04 | |
| | Hexane (parts) | | | | | | | 73.4 |
| | Toluene (parts) | | | | | 20 | | |
| Dispersion stabilizer | Anionic surfactant (parts) | | | | 0.313 | 0.4 | 0.18 | |
| | Mg(OH)₂ (parts) | 8 | | | 8 | | | 8 |
| Washing step | Number of washing times (times) | 0 | 1 | 2 | 2 | | | 3 |
| | Particle aggregation state after pH adjustment | No aggregation found | No aggregation found | No aggregation found | No aggregation found | | | Aggregation found |
| | Dv (µm) | 2.28 | | | 2.19 | 0.44 | 0.4 | 3.2 |
| | Void ratio (%) | 70 | | | 70 | 55 | 36 | 80 |
| | Residual monomer content (ppm) | 1000 | | | 1300 | 23000 | 20000 | 35000 |
| | Aqueous dispersion conductivity (µS/cm) | 1400 | 210 | 70 | 490 | 550 | 400 | 120 |
| | Aqueous dispersion pH | 9.1 | 8.7 | 8.2 | 9.0 | 9.0 | 8.8 | 8.5 |
| Hollow particles | Surfactant content (ppm) | ND | ND | ND | 300 | 250 | 130 | ND |
| | Metal content (ppm) | 8720 | 4200 | 1030 | 240 | 6 | 160 | 1500 |
| | Relative permittivity (@ 10 GHz) | 1.39 | 1.36 | 1.36 | 1.35 | 1.45 | 1.80 | 1.30 |
| | Dielectric dissipation factor (@ 10 GHz) | 9.04E-03 | 2.24E-03 | 1.70E-03 | 1.55E-03 | 1.60E-03 | 9.10E-03 | 2.00E-03 |
| | Pressure resistance test (Residual void ratio (%)) | 100 | 100 | 100 | 100 | 30 | 80 | 60 |
| | Reliability test | E | D | C | D | E | D | C |

Table 1 shows the amount (parts by mass) of the added materials and the measurement or evaluation results.

In Table 1, for simplification, the dielectric dissipation factor values are expressed by using the exponent notation defined in JIS X 0210. For example, the term "8.44×10⁻⁴" is expressed as "8.44E-04".

The meaning of the abbreviations shown in Table 1 are as follows.
DVB: Divinylbenzene
EVB: Ethylvinylbenzene
St: Styrene
MMA: Methyl methacrylate
α-MSt: α-Methylstyrene
50 PEP-300: Polyethylene glycol-propylene glycol monomethacrylate (product name: BLEMMER (registered trademark) 50 PEP-300, manufactured by: NOF Corporation)

SEM observation was carried out on the surface and cross-section of the hollow particles obtained in Examples and Comparative Examples. From the SEM observation results and the void ratio values, the hollow particles obtained in Examples and Comparative Examples (excluding Comparative Example 6) were found to be spherical particles having only one hollow portion. A crack or dent was found on the hollow particles obtained in Comparative Example 6. In all of Examples, the percentage of the number of the particles having only one hollow portion was 90% or more.

Also, in all of Examples, 3000 particles were randomly selected from the hollow particles and examined. As a result, in all of Examples, the percentage of the particles having a circularity of 0.85 or less was 10% by mass or less.

### [Consideration]

In Comparative Examples 1 to 7, the aqueous dispersion of the hollow particles obtained by dispersing the hollow particles with a volume of 0.35 cm³ in 100 mL of deionized water, showed a pH of more than 7.5 and a conductivity of more than 50 µS/cm. Accordingly, compared to the hollow particles obtained in Examples, the hollow particles of Comparative Examples had a high dielectric dissipation factor, and they were likely to cause an abnormality in the reliability test, that is, they were poor in the performance stability under high-humidity environment. Also, the hollow particles obtained in Comparative Examples 5 and 6 had poor pressure resistance, since the content of the crosslinkable monomer unit was less than 60% by mass. The hollow particles obtained in Comparative Example 7 had poor pressure resistance, since the residual monomer content was large.

Meanwhile, in Examples, the aqueous dispersion of the hollow particles obtained by dispersing the hollow particles with a volume of 0.35 cm³ in 100 mL of deionized water showed a pH of 6.5 or more and 7.5 or less and a conductivity of 50 µS/cm or less. Accordingly, the hollow particles obtained in Examples had a low dielectric dissipation factor, and they were less likely to cause an abnormality in the reliability test, that is, they were excellent in the performance stability in high-humidity environment. Also, the hollow particles obtained in Examples had excellent pressure resistance, and they were able to have a high void ratio of 50% or more, accordingly, since the content of the crosslinkable monomer unit was 60% by mass or more in 100% by mass of all the monomer units of the polymer contained in the shell. It is estimated that the sufficiently high void ratio contributed to the low dielectric dissipation factor of the hollow particles obtained in Examples. It is also estimated that the large content of the hydrocarbon monomer unit contributed to the low dielectric dissipation factor of the hollow particles obtained in Examples. The hollow particles obtained in Examples 3 to 5 contained the crosslinkable hydrocarbon monomer unit in combination with the non-crosslinkable hydrocarbon monomer unit, and the ratio of the non-crosslinkable hydrocarbon monomer unit was large. Accordingly, compared to the hollow particles obtained in Examples 1 and 2, the dielectric dissipation factor was further decreased of the hollow particles obtained in Examples 3 to 5, and the hollow particles obtained in Examples 3 to 5 were particularly excellent in dielectric property.

### [Example 6]

### (1) Preparation of resin composition

As the resin composition of Example 6, the same varnish as the resin varnish prepared in Example 2 (the resin varnish containing the hollow particles prepared in "9-1. Preparation of resin varnish containing hollow particles" under "9. Reliability test in high-humidity environment") was used. The amounts of the added materials were adjusted so that the total solid content of the resin composition was 100 parts by mass.

More specifically, 90 parts of brominated epoxy resin (product name: YDB-500EK75, manufactured by: Tohto Kasei Co., Ltd., epoxy equivalent: 500, solid content: 75% by mass) and 10 parts of cresol novolac-type epoxy resin (product name: YDCN220EK75, manufactured by: Tohto Kasei Co., Ltd., epoxy equivalent: 210, solid content: 75% by mass) as a matrix resin, were dissolved in a mixed solvent (room temperature) of 20 parts of dimethylformamide (DMF) and 6 parts of methyl ethyl ketone (MEK). In addition, 2 parts of dicyandiamide (DICY) (manufactured by Nippon Carbide Industries, Co., Inc.) as a curing agent and 0.1 parts of 2-ethyl-4-methylimidazole (product name: CUREZOL (registered trademark) 2E4MZ, manufactured by: Shikoku Chemicals Corporation) as a curing accelerator, were added thereto, and they were mixed by stirring, thereby preparing a resin varnish.

Next, the resin varnish was cooled to room temperature, and 118 parts of the cooled resin varnish (solid content 94 parts) and 6 parts of the hollow particles prepared in Example 2 were mixed by stirring with a dispersion mixer at 3000 rpm for 30 minutes, thereby preparing the resin composition of Example 6. Table 2 shows the contents (parts by mass) of the components contained in the obtained resin composition.

### (2) Production of resin molded body (cured product)

The obtained resin composition was filled into an aluminum mold in which a TEFLON (registered trademark) sheet was placed. In an oven, the resin composition in the mold was heat-cured for three hours at a temperature condition of 180°C in a nitrogen atmosphere, thereby producing a sheet-shaped resin molded body which is a cured product of the resin composition obtained above.

### [Example 7]

The resin composition and resin molded body (a cured product of the resin composition) of Example 7 were produced in the same manner as Example 6, except that the amount of the added resin varnish was changed to 122.5 parts (solid content 98 parts) and the amount of the added hollow particles was changed to 2 parts.

### [Example 8]

The resin composition and resin molded body (a cured product of the resin composition) of Example 8 were produced in the same manner as Example 6, except that the amount of the added resin varnish was changed to 106.5 parts (solid content 85 parts) and the amount of the added hollow particles was changed to 15 parts.

### [Example 9]

### (1) Preparation of encapsulating resin composition

First, 48.8 parts of an alicyclic epoxy resin(product name: CELLOXIDE 2021P, manufactured by: Daicel Corporation) as a matrix resin, 44.3 parts of methylhexahydrophthalic anhydride (product name: RIKACID (registered trademark) MH, manufactured by: New Japan Chemical Co., Ltd.) as an acid anhydride-based curing agent, and 0.89 parts of 1-benzyl-2-methylimidazole (product name: CUREZOL (registered trademark) 1B2MZ, manufactured by: Shikoku Chemicals Corporation) as a curing accelerator, were mixed by stirring for 15 minutes with a planetary mixer. A mixture thus obtained was cooled to room temperature, and 6 parts of the hollow particles obtained in Example 2 were added to the cooled mixture. They were mixed by stirring with a dispersion mixer at 3000 rpm for 30 minutes, thereby preparing the encapsulating resin composition of Example 9.

### (2) Production of cured product

The obtained encapsulating resin composition was filled into an aluminum mold in which a TEFLON (registered trademark) sheet was placed. In an oven, the resin composition in the mold was heat-cured for three hours at a temperature condition of 180°C in a nitrogen atmosphere, thereby producing a sheet-shaped cured product of the encapsulating resin composition.

### [Examples 10 to 15]

The encapsulating resin compositions and cured products (cured products of the encapsulating resin compositions) of Examples 10 to 15 were produced in the same manner as Example 9, except that the type and amount of the added matrix resin, the amount of the added acid anhydride-based curing agent (RIKACID (registered trademark) MH) or the amount of the added curing accelerator (1B2MZ) was changed according to Table 2.

### [Comparative Example 8]

The encapsulating resin composition and cured product (a cured product of the encapsulating resin composition) of Comparative Example 8 were produced in the same manner as Example 9, except that the hollow particles produced in Comparative Example 2 were used instead of the hollow particles produced in Example 2, and the type and amount of the added matrix resin, the amount of the added acid anhydride-based curing agent (RIKACID (registered trademark) MH) and the amount of the added curing accelerator (1B2MZ) were changed according to Table 2.

### [Evaluation]

The resin compositions and cured products obtained in Examples 6 to 15 and Comparative Example 8 were measured and evaluated as follows. The results are shown in Table 2.

### 10. Residual void ratio

The residual void ratio (%) of the hollow particles contained in each of the cured products obtained in Examples 6 to 15, was calculated from the specific gravity of the cured product and that of the hollow particles added to the cured product.

### 11. Dielectric dissipation factor decrease rate

As a measurement sample, a small piece (width 2.6 mm, length 80 mm, thickness 40 µm) was cut from each of the cured products obtained in Examples 6 to 15 and Comparative Example 8. The dielectric dissipation factor of the measurement sample at a frequency of 10 GHz and at room temperature (25°C) was measured with a permittivity-dielectric dissipation factor measuring device by the cavity resonator perturbation method.

Meanwhile, a cured product not containing hollow particles was produced in the same manner as Examples 6 to 15 and Comparative Example 8, except that hollow particles were not added. The dielectric dissipation factor of the cured product not containing hollow particles was measured in the same manner as above.

The dielectric dissipation factor decrease rate of each of the cured products obtained in Examples 6 to 15 and Comparative Example 8, which contained the hollow particles, was calculated by the following formula and evaluated according to the following evaluation criteria.

In the following formula, Df1 is the dielectric dissipation factor of the cured product containing the hollow particles, and Df2 is the dielectric dissipation factor of the cured product obtained in the same condition except for not containing hollow particles. Dielectric dissipation factor decrease rate (%) = {(Df2 - Df1) / Df2} × 100

### (Evaluation criteria)

A: The dielectric dissipation factor decrease rate was 12% or more.
B: The dielectric dissipation factor decrease rate was 6% or more and less than 12%.
C: The dielectric dissipation factor decrease rate was less than 6%.

### 12. Reliability test in high-humidity environment

Using each of the resin compositions obtained in Examples 6 to 15 and Comparative Example 8, a prepreg was obtained in the same manner as "9-2. Production of prepreg" under "9. Reliability test in high-humidity environment".

Using the obtained prepreg, a double-sided copper clad laminate was obtained in the same manner as "9-3. Production of double-sided copper clad laminate" under "9. Reliability test in high-humidity environment".

Using the obtained double-sided copper clad laminate, evaluation was carried out in the same manner as and according to the same evaluation criteria as "9-4. Reliability test" under "9. Reliability test in high-humidity environment".

### [Table 2]

**Table 2**

| | | | Example 6 | Example 7 | Example 8 | Example 9 | Example 10 | Example 11 | Example 12 | Example 13 | Example 14 | Example 15 | Comparative Example 8 |
|---|---|---|---|---|---|---|---|---|---|---|---|---|---|
| Hollow particles | | Type | Example 2 | | | | | | | | | | Comparative Example 2 |
| | | (parts) | 6 | 2 | 15 | 6 | 6 | 6 | 6 | 6 | 6 | 6 | 6 |
| | Brominated epoxy resin | YDB-500EK75 | 82.9 | 86.4 | 74.9 | | | | | | | | |
| | Cresol novolac-type epoxy resin | YDCN220EK75 | 9.2 | 9.6 | 8.3 | | | | | | | | |
| | Alicyclic epoxy resin | CEL2021P | | | | 48.8 | 31.0 | 30.3 | 33.3 | 24.5 | 30.6 | 33.0 | 33.3 |
| | | EHPE3150 | | | | | 17.7 | | | | | | |
| Matrix resin (parts) | | CEL2081 | | | | | | 19.5 | | | | | |
| | | GT401 | | | | | | | 17.1 | 9.8 | | | 17.1 |
| | | THI-DE | | | | | | | | 9.8 | | | |
| | Bisphenol A-type epoxy resin | jER828EL | | | | | | | | | 18.8 | | |
| | Biphenyl aralkyl-type epoxy resin | NC-3000-L | | | | | | | | | | 19.0 | |
| Curing accelerator (parts) | | 2E4MZ | 0.09 | 0.10 | 0.08 | | | | | | | | |
| | | 1B2MZ | | | | 0.89 | 0.89 | 0.87 | 0.85 | 0.98 | 0.87 | 0.82 | 0.85 |
| Curing agent (parts) | | DICY | 1.84 | 1.92 | 1.67 | | | | | | | | |
| | | RIKACID MH | | | | 44.3 | 44.3 | 43.3 | 42.7 | 49.0 | 43.7 | 41.2 | 42.7 |
| Residual void ratio (%) | | | 100 | 100 | 100 | 100 | 100 | 100 | 100 | 100 | 100 | 100 | 100 |
| Dielectric dissipation factor decrease rate | | | A | B | A | A | A | A | A | A | A | A | B |
| Reliability test | | | A | A | A | A | A | A | A | A | A | A | C |

The meaning of the abbreviations shown in Table 2 are as follows.
YDB-500EK75: "YDB-500EK75" (product name, a brominated epoxy resin manufactured by Tohto Kasei Co., Ltd.)
YDCN220EK75: "YDCN 220EK75" (product name, a cresol novolac-type epoxy resin manufactured by Tohto Kasei Co., Ltd.)
CEL2021P: "CELLOXIDE 2021P" (product name, the compound represented by the following formula (B), manufactured by Daicel Corporation)
EHPE3150: "EHPE 3150" (product name, the compound represented by the following formula (C), manufactured by Daicel Corporation)
CEL2081: "CELLOXIDE 2081" (product name, the compound represented by the following formula (D), manufactured by Daicel Corporation)
GT401: "EPOLEAD GT401" (product name, the compound represented by the following formula (E), manufactured by Daicel Corporation)
THI-DE: "EPOCHALIC (registered trademark) THI-DE" (product name, the compound represented by the following formula (F), manufactured by ENEOS Corporation)
jER828EL: "jER 828EL" (product name, a bisphenol A-type epoxy compound manufactured by Mitsubishi Chemical Corporation, epoxy equivalent 189)
NC-3000-L: "NC-3000-L" (product name, a biphenyl aralkyl-type epoxy compound manufactured by, Nippon Kayaku Co., Ltd., epoxy equivalent 269)
2E4MZ: "CUREZOL (registered trademark) 2E4MZ" (product name, 2-ethyl-4-methylimidazole manufactured by Shikoku Chemicals Corporation)
1B2MZ: "CUREZOL (registered trademark) 1B2MZ" (product name, 1-benzyl-2-methylimidazole manufactured by Shikoku Chemicals Corporation)
DICY: dicyandiamide manufactured by Nippon Carbide Industries, Co., Inc.
RIKACID MH: "RIKACID MH" (product name, methylhexahydrophthalic anhydride manufactured by New Japan Chemical Co., Ltd.)

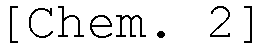

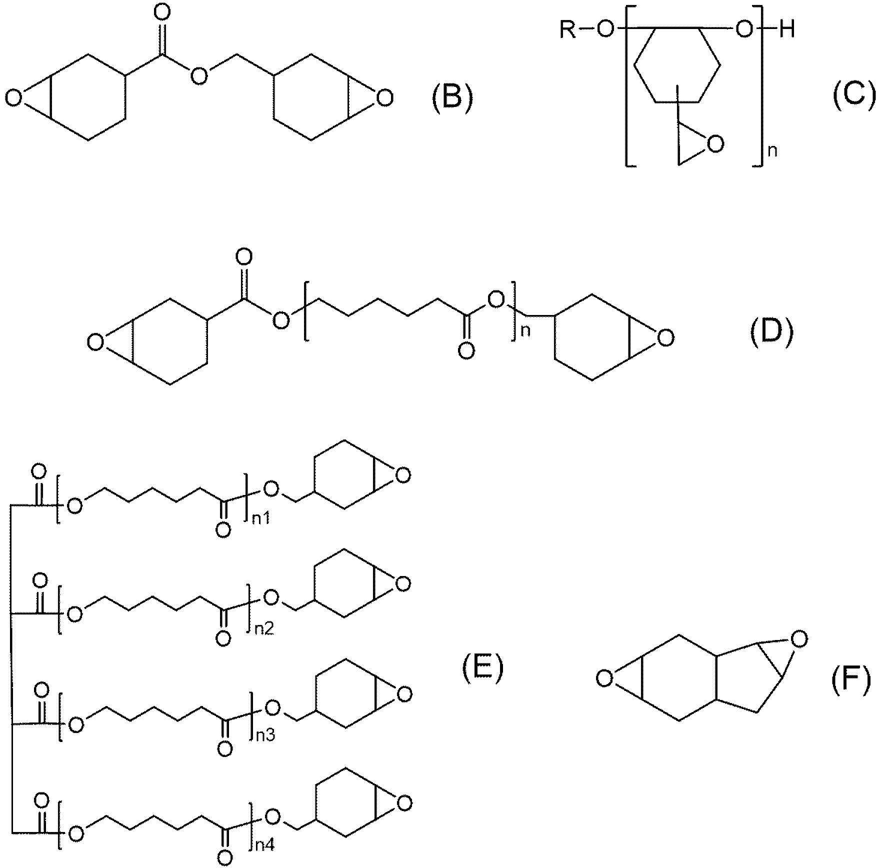

In the formulae (C) and (D), n is an integer of 1 or more. In the formula (E), each of n1, n2, n3 and n4 is an integer of 0 or more.

### [Consideration]

The resin composition and resin molded body (a cured product of the resin composition) obtained in Comparative Example 8 contained the hollow particles of Comparative Example 2. The aqueous dispersion of the hollow particles of Comparative Example 2 showed a pH of more than 7.5 and a conductivity of more than 50 µS/cm. Accordingly, the resin composition and resin molded body (a cured product of the resin composition) obtained in Comparative Example 8 were likely to cause an abnormality in the reliability test, that is, they were poor in the performance stability in high-humidity environment. Also in Comparative Example 8, the dielectric dissipation factor decrease rate was small compared to Examples in which the same amount of hollow particles were added; moreover, the effect of reducing the dielectric dissipation factor exerted by the hollow particles was poor.

Meanwhile, the resin composition and resin molded body (a cured product of the resin composition) obtained in each of Examples 6 to 15 contained the hollow particles of Example 2. The aqueous dispersion of the hollow particles of Example 2 showed a pH of 6.5 or more and 7.5 or less and a conductivity of 50 µS/cm or less. Accordingly, the resin composition and resin molded body (a cured product of the resin composition) obtained in each of Examples 6 to 15 had a large dielectric dissipation factor decrease rate; moreover, they were less likely to cause an abnormality in the reliability test, that is, they were excellent in the performance stability in high-humidity environment. Therefore, it was revealed that the resin composition and resin molded body of the present disclosure, both of which contain the hollow particles of the present disclosure and the matrix resin, are those in which, because of containing the hollow particles, a reduction in the performance stability in high-humidity environment is suppressed, while the dielectric dissipation factor is decreased.

### Reference Signs List

1. Aqueous medium
1a. Deionized water
2. Low polarity material
3. Monomer composition droplet
4a. Hydrophobic solvent
4b. Material not containing hydrophobic solvent
5. Precursor particle
6. Shell
7. Hollow portion
10. Hollow particle in which the hollow portion is filled with gas

## Claims

1. Hollow particles comprising a shell, which contains a resin, and a hollow portion surrounded by the shell,
wherein the hollow particles have a void ratio of 50% or more;
wherein the shell contains a polymer as the resin, and a content of a crosslinkable monomer unit is 60% by mass or more in 100% by mass of all monomer units of the polymer; and
wherein an aqueous dispersion of the hollow particles, which is obtained by dispersing the hollow particles with a volume of 0.35 cm³ in 100 mL of deionized water, has a pH of 6.5 or more and 7.5 or less and a conductivity of 50 µS/cm or less.

2. The hollow particles according to Claim 1, wherein a content of a hydrocarbon monomer unit is more than 50% by mass in 100% by mass of all the monomer units of the polymer.

3. The hollow particles according to Claim 1 or 2, wherein the hollow particles have a metal content of 700 ppm or less.

4. The hollow particles according to Claim 1 or 2, wherein a content of a surfactant present on a surface of the hollow particles is 200 ppm or less.

5. The hollow particles according to Claim 1 or 2, wherein the hollow particles have a dielectric dissipation factor at a frequency of 10 GHz of 1.00 × 10⁻³ or less.

6. The hollow particles according to Claim 1 or 2, wherein the hollow particles have a relative permittivity at a frequency of 10 GHz of 1.00 or more and 1.40 or less.

7. The hollow particles according to Claim 1 or 2, wherein the hollow particles have a void ratio of 70% or more.

8. A resin composition comprising the hollow particles defined by any one of Claims 1 to 7 and a matrix resin.

9. A resin molded body obtained from the resin composition defined by Claim 8.

10. An encapsulating resin composition comprising the hollow particles defined by any one of Claims 1 to 7 and an epoxy resin.

11. The encapsulating resin composition according to Claim 10, wherein the epoxy resin comprises an alicyclic epoxy resin.

12. The encapsulating resin composition according to Claim 11, wherein the epoxy resin further comprises an epoxy resin free of an alicyclic structure.

13. The encapsulating resin composition according to Claim 10, further comprising a curing accelerator.

14. The encapsulating resin composition according to Claim 10, wherein a content of the hollow particles is from 1 part by mass to 70 parts by mass, with respect to 100 parts by mass of a total solid content of the encapsulating resin composition.

15. A cured product of the encapsulating resin composition defined by Claim 10.

16. A semiconductor device comprising the cured product defined by Claim 15 as an encapsulant.
